# EUROPEAN PATENT APPLICATION

(11) **EP 0 713 248 A2**
(43) Date of publication of application: **22.05.1996**
(21) Application number: 95307982.9
(22) Date of filing: 08.11.1995
(51) Int. Cl.: H01L 21/56

(54) **Molding method and apparatus**

(30) Priority: 17.11.1994 JP 283277/94; 17.11.1994 JP 283278/94; 26.04.1995 JP 101833/95; 31.08.1995 JP 224245/95
(71) Applicant: HITACHI, LTD., Chiyoda-ku, Tokyo 100 (JP); HITACHI TOKYO ELECTRONICS CO., LTD., Ome-shi Tokyo (JP)
(72) Inventor: Shimizu, Tsuyoshi, Nishitama-gun, Tokyo (JP); Kohzu, Kenji, Kodaira-shi (JP)
(74) Representative: Paget, Hugh Charles Edward

(57) **Abstract**

A molding apparatus for manufacturing a high-quality semiconductor integrated circuit device has such a simplified structure as removing air vents (85) and ejector pins (26, 36). The molding apparatus has a function of preventing any foam, sink and resin flash on a mold. Plural semiconductor chips are fitted to a lead frame (42) for composing a chip-lead compound (40). This chip-lead compound (40) is placed between an upper and a lower dies (76, 78) provided in the molding apparatus. When the dies (76, 78) are matched with each other, mold cavities (43) are formed. At least a part of each mold cavity (43) is formed of such a porous material as inhibiting intrusion of mold resin and allowing gas components to pass therethrough for preventing occurrence of voids. When mold clamping is performed in the state that the chip-lead compound (40) is placed between the dies (76, 78), resin is implanted into the mold cavities (43), when the inside of each mold cavity (43) is opened to the atmosphere through a porous material or is set to have a far smaller pressure than the implanting pressure of the mold resin. The molding apparatus provides a two-stage ventilating portion (123b, 124b, 150a, 151a) in at least one of the upper and the lower dies (123, 124). The ventilating portions serve to guide out the air left in the resin press-fitting portions (130, 131). The ventilating portions are made porous and having base ventilating portions (123b, 124b) provided in the upper or the lower die (123 or 124) and surface ventilating portions (150a, 151a) located on the surfaces of the base ventilating portions (123b, 124b) and contacting the molten resin (128). The surface ventilating portion (150a or 151a) has pores (90) in smaller diameter than the base ventilating portion (123b or 124b) and is replaceable. The surface ventilating portion (150a or 151a) is formed by transforming an extensible porous film (150 or 151) stretched on each parting face (123a or 124a) of the upper and the lower dies (123, 124). The two-stage ventilating portions (123b, 124b, 150a, 151a) provide sucking means and compressed gas supplying means.

## Description

### BACKGROUND OF THE INVENTION

The present invention relates to a method and an apparatus for manufacturing a semiconductor integrated circuit device which method and apparatus contain a molding process for sealing a semiconductor chip with mold resin, and more particularly to a technique that may effectively apply to a transfer molding technique provided in the molding apparatus for manufacturing a semiconductor chip.

For assembling as a resin molding apparatus, that is, a molding apparatus a resin-sealed semiconductor IC device in which a semiconductor chip or a pellet is sealed by a heat-hardening mold resin such as a QFP (Quad Flat Package) type semiconductor IC device, the currently used apparatus is such as disclosed in J-P-A 52-95765.

Also, a molding process is provided for manufacturing a resin-sealed semiconductor device having a DIP (Dual In-Line Package) or a QFP (Quad Flat Package) structure. In this molding process, a part of a lead frame is sealed by a transfer molding apparatus, and its relevant parts such as a semiconductor chip, wires and the inner ends of the lead are covered by a sealing material such as resin.

The transfer molding apparatus is located on a conveying path of a lead frame between a loader and an unloader. After a semiconductor chip is bonded on the lead frame, the loader serves to put the lead frame into the transfer molding apparatus, in which a package is formed on the lead frame. Then, the resulting semiconductor chip is sealed with resin. The lead frame having the package formed thereon is taken out of the molding apparatus and then is put into the unloader.

The molding apparatus has an upper die and a lower one for forming mold cavities when these dies are matched with each other. Within each mold cavity is located a lead frame having plural semiconductor chips fixed thereon. In this state, molten resin is filled in the mold cavity. The molten resin is flown from a pot formed in the die to the cavity through runners and resin gates.

The molding apparatus provides an air vent for preventing some shortcomings such as air inclusion and resin shortage, which may appear when the resin is filled in the cavity, at each corner of each cavity portion except the resin gate. Apparently, this air vent is intended for completely filling the mold resin in the cavities. Air left in each cavity is discharged from the air vent to the outside. After the resin implanted into the cavity is hardened, that is, a mold is formed, to take out the mold form from the die, the die provides ejector pins. Each ejector pin is projected into the cavity for separating from the dies the lead frame having culls and molded portion corresponding to runners and resin gates.

The transfer molding apparatus is described in "VLSI Packaging Technique (Last Volume)" Nikkei BP.edition, May 15, 1993, pages 34 to 40, for example. This publication describes that the upper and the lower dies provide the corresponding heaters. The upper die is supported by a movable panel that is vertically moved along a guide and is fitted to the lower die for mold clamping. Further, the publication also has a chart illustrating a molding routine. In the chart, the lead frame is placed on the lower die and the upper die (mould) is pressed down onto the lower die for mold clamping. Then, a preliminary heated tablet is put into a pot. The tablet is molten in the pot through the effect of a heater. The molten resin is filled into the cavity under the pressure given by a plunger. Air left in the cavity is discharged out through the air vent.

In addition, about an IC mold structure and its main parts, the article "Semiconductor die CAD / CAM System - Summary" is described in the magazine "Electronic Materials" of an October 1987 issue, pages 81 to 86, edited by Industrial Research Society, published on October 1 1987. This article describes an ejector pin unit having ejector pins, a keep plate, a press platen, and a chase block.

On the other hand, as means of reducing voids (foams) in the mold and defective wire flow, an over runner or a dummy cavity located on the resin flow path is described in the magazine "Electronic Materials" of an August 1987, pages 73 to 79, edited by Industrial Research Society, and published on August 1, 1987.

For preventing occurrence of voids, there is known a technique wherein a flow cavity is located outside of the air vent. Since the tip of the resin intruded into the cavity entrains air, the air-included resin is guided from the air vent to the flow cavity for storing the resin therein. The flow cavity technique is described in Japanese Patent Application No. Hei 4-314506.

Japanese Unexamined Laid-open No. 62-135330 also discloses a method for forming a mold. This method uses a die formed so that porous metal tips are inserted in continuous pores formed in the cavity. When the mold is separated from the die, gas is supplied from the outside through the metal tips. The Japanese Unexamined Laid-open No. Hei 5-74827 discloses a metallic die having ejector pins each formed of porous metal.

When forming a package for sealing a semiconductor chip in a lead frame, some adverse factors may make the flowing pace of the resin in the cavity variable in the upper and the lower spaces of the lead frame. Those adverse factors are such as the difference of the flowing pace of the resin between the upper space and the lower space of the lead frame, between the upper space of the lead frame and the upper space of the semiconductor chip or between the lower space of the lead frame and the lower space of the semiconductor chip.

If such a phenomenon takes place, the resin flowing at a faster pace reaches the air vent and blocks the air vent. Hence, the air left in the cavity is disallowed to be discharged out of the die, that is, confined in the cavity. The application of an implanting pressure to the air-included resin reduces a volume of the left air but may bring about foams or sinks in the package. They may be adverse factors and lower reliability of quality of the package.

Further, if the resin is leaked by the implanting pressure applied from the air vent, leaked resin adheres to the lead frame or the air vent as flash. The flash on the lead frame is may be dropped when cutting or bending the lead frame in the later process. The dropped flash may impair the package.

If the resin flash adheres to the air vent, the air vent is clogged. This may bring about defective resin filling when molding the package.

On the other hand, for separating the molded product from the metallic die, in other words, taking the product out of the die, the die contains plural ejector pins, so that the die may be so complicated. To design and manufacture the die, a lot of time and cost are required. As to the die for molding the thin product, when separating the molded product having culls and the corresponding portions to the runners and the resin gates from the dies with the ejector pins, concave portions may be formed on the surface of the molded product. Those concave portions may be defective portions such as chip cracks or package slits.

Moreover, the conventional transfer molding apparatus is arranged to discharge the air left inside of the cavity out of the air vent. Hence, a small amount of resin is leaked to the air vent with the air. The resin hardened in the air vent is so thin that it may be easily chipped. In the cutting process subsequent to the sealing process, if the resin is chipped and dropped onto the cutting die, the chipped resin may impair or transform the outer lead.

In a case that the transfer molding apparatus is continuously in operation, the adhesive resin is accumulated in the air vent so that the accumulated resin may clog the air vent. This may bring about shortage of filling resin in the cavity. This shortage of filling resin may bring about foams (voids) and sinks, which result in lowering the quality of the molded product (semiconductor device).

In the die for forming the thin product (semiconductor device), when separating the molded semiconductor device containing culls and the corresponding portions to the runners and the gates from the dies with the ejector pints, the mold (resin package) is pricked by the ejector pins. This pricking bring about concave portions on the surface of the mold or may sometimes bring about chip cracks or package slits.

For preventing the voids, the die provides over-runners, dummy cavities, air vents, flow cavities and ejector pins for thrusting the molded product (semiconductor device) from the cavities. Hence, the die pattern is so complicated that it needs a lot of time and cost for its design and manufacture.

### SUMMARY OF THE INVENTION

It is an object of the present invention to provide a molding method and apparatus that enable to manufacture a semiconductor integrated circuit device having a high-quality resin sealing portion having no foams and sinks.

It is a further object of the present invention to provide a molding method and apparatus that enable to prevent occurrence of resin flash for manufacturing a semiconductor integrated circuit device having a high-quality resin sealing portion.

It is a yet further object of the present invention to provide a molding method and apparatus that enable to separate a lead frame having a resin sealing portion molded thereon from a die without having to use ejector pins.

It is another object of the present invention to provide a molding method and apparatus that enable to prevent defective transform of an outer lead and occurrence of any impairment.

It is another object of the present invention to provide a molding method and apparatus that enable to suppress bubbles and sinks on the mold as much as possible.

It is another object of the present invention to provide a molding method and apparatus that enable to prevent chip cracks and package slits caused when ejector pins prick the mold surface.

It is another object of the present invention to provide a molding apparatus that has simply patterned dies.

The foregoing and the other objects and the new features will be apparent from the following description and the appended drawings.

The summary of the representative one of the inventions disclosed in the present application will be briefly described below.

A method for manufacturing a semiconductor integrated circuit according to an aspect of the invention includes a step of preparing a chip-lead compound made of a lead frame or a thin wired sheet containing plural semiconductor chips and plural inner leads directly or indirectly electrically coupled on an electrode formed on a first main face of each of those chips; a step of locating the chip-lead compound between a first die and a second die in the molding apparatus made of a porous material and having the first die and the second die for forming plural mold cavities for sealing the semiconductor chips in concert with the first die, in which at least one portion of the inner surface of the mold cavity of at least one of the first and the second dies serves to inhibit intrusion of the mold resin down to a predetermined depth and pass at least part of gas components for preventing occurrence of voids; a step of pressing both of the dies against each other in the state of locating the chip-lead compound between the upper and the lower dies; a step of exposing the mold cavity formed by the clamped dies toward the atmosphere through the portion made of a porous material or implanting the mold resin into the mold cavity at a far lower pressure than the implanting pressure of the mold resin and sealing a predetermined portion of the chip-lead compound with the mold resin; and a step of separating the sealed chip-lead compound from at least one of the first and the second dies.

The chip-lead compound is separated from the dies by injecting gas into the mold cavities through the portion made of the porous material.

When the mold resin is injected to the mold cavities, the gas may be sucked and discharged from the mold cavities into the outside.

The method for manufacturing a semiconductor integrated circuit device includes the step of discharging out the gas left in the mold cavities through air vents made of the porous material forming at least one of these two dies when implanting the molten resin in the mold cavities formed by these dies in the state of contacting the first die with the second die.

The method for manufacturing a semiconductor integrated circuit device includes the step of locating the chip-lead compound between the first die and the second die in the molding apparatus having the first die and the second die for forming plural mold cavities for sealing plural semiconductor chips in concert with the first die, in which apparatus the almost of the surface of each mold cavity is formed of a porous material and serves to inhibit intrusion of the mold resin to a predetermined depth and at least part of gas components are allowed to pass through the porous material, for preventing occurrence of voids.

The method for manufacturing a semiconductor integrated circuit device includes the step of locating the chip-lead compound between the first and the second dies in the molding apparatus having the first die, the second die designed to have plural mold cavities for sealing plural semiconductor chips together with the first die, in which apparatus at least an opposite portion to each inside of those mold cavities to a gate is formed of a porous material and serves to inhibit intrusion of the mold resin down to a predetermined depth and at least part of gas components are allowed to pass through the porous material, for preventing occurrence of voids.

The method for manufacturing a semiconductor integrated circuit device includes the step of locating the chip-lead compound between the first die and the second die in the molding apparatus having the first die and the second die designed to have plural mold cavities for sealing plural semiconductor chips together with the first die, one or more pots for accommodating one or more resin tables, and one or more runners for connecting them, in which apparatus at least part of each inside of the pots, the runners and at least part of an inside of a plunger slidably provided in each of the pots serve to inhibit intrusion of the mold resin down to a predetermined depth and at least part of gas components are allowed to pass through the porous material, for preventing occurrence of voids.

The method for manufacturing a semiconductor integrated circuit includes the step of inserting a resin tablet to a resin tablet inserting portion provided in the lower die through a space between the upper die and the lower die in the molding apparatus having the upper die and the lower die designed to have plural mold cavities for sealing plural semiconductor chips, plural pots for accommodating resin tables for a predetermined number of mold cavities, respectively, and plural runners for connecting them, in which apparatus at least part of each inside of the mold cavities, the pots, and the runners are formed of a porous material and serves to inhibit intrusion of the mold resin down to a predetermined depth, for preventing occurrence of the mold resin.

The method for manufacturing a semiconductor integrated circuit device includes the step of separating the sealed chip-lead compound from at least one of the first and the second dies by separating the first die from the second die as gas is being injected to the mold cavity through a porous material after the mold resin is implanted to the mold cavity, and is executed to manufacture a thin resin sealed semiconductor integrated circuit device whose characteristic is degraded by physical transformation of the sealing portion if the sealing portion is separated by the ejector pins provided in the molding apparatus.

The method for manufacturing a semiconductor integrated circuit device includes the step of implanting molten mold resin to the mold cavities formed by the first and the second dies and discharging only gas in the mold cavities in the state of clamping the first and the second dies with each other, the first die having a main body with ventilating portions made of a porous material and having air vents and a filter layer formed on the surface of the main body and having pores communicating with the air vents, inhibiting inflow of mold resin molecules to the pores and allowing only the flow of gas, the communicating pores having smaller inner diameters than the air vents.

A molding apparatus according to an aspect of the invention includes a first die, a second die designed to relatively come closer to or off the first die and have mold cavities formed to correspond to packages in concert with the first die, at least one of the first and the second dies having a main body formed to contain a ventilating portion made of a porous material and having air vents, the surface of the ventilating portion having a filter layer containing pores communicating with the air vents, the communicating pores serving to inhibit inflow of mold resin to the air vents and allowing flow of only gas into the air vents.

A molding apparatus according to the invention includes a first die, a second die designed to relatively move closer to or off the first die and form mold cavities suited to correspond to packages in concert with the first die, at least one of the first and the second dies being formed of a main body providing a ventilating portion made of a porous material and having air vents and a fine porous portion buried to a predetermined depth from the inner surface of each mold cavity and formed to have communicating pores containing smaller inner diameters than the air vents, those communicating pores for preventing intrusion of mold resin and allowing passage of at least part of gas components. A coating layer may be formed on the surface of the fine porous portion.

According to the present invention, in the state of opening the mold cavities formed by the closed dies to the air through the porous portion or lowering the implanting pressure of the mold resin when the mold resin is implanted to the mold cavities, gas such as air left in the mold cavities are discharged out. Hence, the molding apparatus of the invention enables to manufacture a semiconductor integrated circuit device having a high-quality resin sealing portion with no foams and sinks left in the cavities. The gas left in the mold cavities may be discharged out of the whole or the part of each mold cavity.

By forming at least part of the pots, the runners, or the plungers of a porous material, gas such as air left in the pot or the runner may be discharged out while the mold resin is guided from the pot to the corresponding mold cavity.

When separating the sealed chip-lead compound from the die, the gas is injected from the outside to the cavity. Hence, the chip-lead compound is allowed to be taken out without having to use the ejector pins. Even for manufacturing the semiconductor integrated circuit device having a thin resin sealing portion, a high-quality device may be manufactured without having to physically transform the sealing portion.

On the surface of the main body of the die made of a porous material, a filter layer is formed. This filter layer provides pores communicating with air vents and having a smaller diameter than the air vents. Hence, the filter layer serves to positively prevent inflow of the mold resin to the air vents.

Further, since the fine porous medium is buried into a predetermined depth of each communicating pore, it is possible to positively prevent inflow of the mold resin into the air vents.

The summary of a more representative one of the inventions disclosed in the present application will be described below.

(1) In the molding method for manufacturing a molded product by press-fitting molten resin to a resin press-fitting portion (such as cavities) formed in the state of matching the lower die with the upper die, when molding the product, air left in the resin press-fitting portion is discharged out of the dies through a two-stage ventilating portion having a base ventilating portion formed on the upper and the lower dies (at least one of the dies) and a surface ventilating portion located on the surface of the base vent and contacting with the molten resin when press-fitting the molten resin. The surface ventilating portion is made of a porous material and is exchanged with a new one at a predetermined number of moldings. The surface ventilating portion is formed of an extensible porous film stretchably pasted on each parting face of the upper or the lower die. The porous film is transformed by mold clamping the upper and the lower dies and press-fitting the resin when the surface ventilating portion is formed. Further, when the dies are separated from each other, the molded product is separated from the upper and the lower dies by the restoring force, that is, the flattening force of the porous filter. When press-fitting the resin, the air left in the resin press-fitting portions is forcibly discharged outside through the air vents. When the dies are separated from each other, the compressed air is supplied to the resin press-fitting portions through the air vents for releasing the molded product from the upper and the lower dies.
(2) In the molding apparatus for manufacturing a molded product by press-fitting molten resin to a resin press-fitting portion (such as cavity) formed by matching the lower die with the upper die, a two-stage ventilating portion is provided on the upper and lower dies. This ventilating portion serves to guide air left in the resin press-fitting portion out of the dies. The two-stage ventilating portion is made of base ventilating portions and surface ventilating portions located on the base ventilating portions and contacting with the molten metal. The surface ventilating portion and the base ventilating portion are both formed of a porous material. The surface ventilating portion has smaller pores than the base ventilating portion and is exchanged with a new one. The surface ventilating portion is formed of an extensible porous film stretchably pasted on each parting face of the upper and the lower dies. Further, a porous film feeding mechanism is provided for supplying the porous film between the parting faces of the upper and the lower dies at a predetermined number of moldings (for example, once). The molding apparatus further provides sucking means connected to the two-stage ventilating portion and for forcibly discharging air from the resin press-fitting portions to the outside of the dies and compressed gas supply means connected to the two-stage ventilating portion and for supplying compressed air to the resin press-fitting portions. The sucking means is operated when the resin is press-fitted, and the compressed gas supply means is operated when the dies are separated from each other.

In the foregoing molding method (1) and the foregoing molding apparatus (2), the following advantages may be obtained:
(a) The upper and the lower dies each provide a two-stage ventilating portion for guiding the air left in the resin press-fitting portion (such as a cavity) out of the die. No slot air vent is, therefore, required on each parting face of the upper and the lower dies. Moreover, It is possible to prevent defective transformation and occurrence of any flow on an outer lead resulting from the drop of resin hardened in the air vent.
(b) No air vent is provided. Hence, no resin clogging in the air vent takes place, so that the sufficient resin is allowed to be filled in the cavity. Further, no foam (voids) or sink takes place in the molded portion, which leads to preventing the quality of the molded product (semiconductor device) from being lowered.
(c) Since the two-stage ventilating portion is provided for guiding the air left in the resin press-fitting portions out of the dies, it is not necessary to provide components for preventing occurrence of voids such as an over-runner, a dummy cavity, an air vent and a flow cavity. This makes it easier to design the die or possible to reduce the die in size.
(d) The ventilating portion is made of the base ventilating portion and the surface ventilating portion. Further, the surface ventilating portion for contacting the molten resin has smaller pores than the base ventilating portion. Hence, no clogging takes place in the base ventilating portion.
(e) Since the surface ventilating portion is exchangeable, the portion is allowed to be exchanged at a predetermined number of moldings. This makes it possible to prevent occurrence of a defective mold caused by the resin clogging.
(f) The surface ventilating portion is formed by transforming an extensible porous film stretchably pasted on each parting face of the upper and the lower dies with the suction and exhaust (and the injecting pressure of the resin). Hence, the proper mold is allowed to be formed without impairing the outer appearance of the mold form.
(g) The surface ventilating portion is formed of an extensible porous tape stretchably pasted on each parting face of the upper and the lower dies. Hence, when the dies are separated from each other, the molded product is allowed to be separated from the upper and the lower dies by means of the restoring force, that is, the flattening force of the porous film. This is a substitution of the ejector pins.
(h) The porous film is supplied between the parting faces of the upper die and the lower die at each molding process and through the effect of a porous film supply mechanism. Hence, no clogging takes place in the surface ventilating portion. It means that the proper mold is allowed to be formed without impairing the outer appearance of the mold form.
(i) Since the sucking means communicating with he ventilating portion is operated when the resin is press-fitted, the air left in the resin press-fitting portion is quickly discharged. This makes it possible to keep the outer appearance of the molded product proper and do the molding with no void. This makes contribution to improving a yield.
(f) The press-fitted gas supply means communicating with the ventilating portion is operated when the dies are separated from each other, and the molded product is pushed out of the upper and the lower dies by the press-fitted gas. Hence, the separation of the molded portion (molded product) is positive.
(k) When the dies are separated from each other, the molded portion is released out of the upper and the lower dies by the restoring force of the porous film and the press-fitted gas supply means. Hence, no ejector pins are required. It means that the ejector pins never prick the molded portion of the molded product, which makes it possible to prevent occurrence of a chip crack or a package crack.
(l) No ejector pin is required, so that the die structure is simplified. This, hence, makes it easier to design and manufacture the die and possible to reduce the manufacturing time and cost.

### BRIEF DESCRIPTION OF THE DRAWINGS

Fig. 1 is a perspective view showing a transfer molding apparatus for performing a sealing process included in a method for manufacturing a semiconductor integrated circuit device according to the present invention;
Fig. 2 is a partially cut-away expanded front view showing an essential part of the transfer molding apparatus shown in Fig. 1;
Fig. 3 is an expanded section showing a clamp molding state of an upper unit and a lower unit shown in Fig. 2;
Fig. 4 is an expanded section showing an opening state of the upper unit and the lower unit shown in Fig. 2;
Fig. 5 is an expanded section showing an upper unit and a lower unit provided in a transfer molding apparatus according to another embodiment of the present invention;
Fig. 6 is a front view showing another type of transfer molding apparatus for performing a sealing process in the method for manufacturing a semiconductor integrated circuit device according to the present invention;
Fig. 7 is a partially cutaway expanded front view showing an essential portion of the transfer molding apparatus shown in Fig. 6;
Fig. 8 is a front view showing a lower die shown in Fig. 7;
Fig. 9 is an expanded section showing each part of the upper and the lower dies shown in Fig. 7;
Fig. 10 is an expanded section showing a part of a main body of the die shown in Fig. 9;
Fig. 11 is an expanded front view showing a part of a lead frame that is released out of the molding apparatus after packaging of the lead frame is completed;
Fig. 12 is a section showing a semiconductor integrated circuit device after an outer lead is bent;
Fig. 13 is a flowchart showing a process for manufacturing the semiconductor integrated circuit device;
Fig. 14 is a front view showing a lower die corresponding to the die shown in Fig. 8 in another type of transfer molding apparatus;
Fig. 15 is a section showing a transformation of the transfer molding apparatus as shown in Figs. 3 and 4;
Fig. 16 is a section showing a transformation of the transfer molding apparatus as shown in Fig. 15;
Fig. 17 is a section showing a transformation of the transfer molding apparatus as shown in Fig. 16;
Fig. 18 is a section showing the portion corresponding to that shown in Fig. 9 in another type of transfer molding apparatus;
Fig. 19 is a section showing the portion corresponding to that shown in Fig. 10 in another type of transfer molding apparatus;
Fig. 20 is a section showing the portion corresponding to that shown in Fig. 19 in still another type of transfer molding apparatus;
Fig. 21 is a model view showing an essential portion of the transfer molding apparatus according to another embodiment (embodiment 11) of the present invention;
Fig. 22 is a perspective view showing an outer appearance of the transfer molding apparatus according to the embodiment 11;
Fig. 23 is a partially cutaway front view showing a molded portion of the transfer molding apparatus according to the embodiment 11;
Fig. 24 is a schematic section showing the dies of the transfer molding apparatus according to the embodiment 11;
Fig. 25 is a schematic section showing the dies located in the molding process done in the transfer molding apparatus according to the embodiment 11;
Fig. 26 is a schematic section showing the opening dies provided in the transfer molding apparatus according to the embodiment 11;
Fig. 27 is a schematic section showing dies provided in another embodiment (embodiment 12) of the present invention;
Fig. 28 is a schematic section showing dies provided in another embodiment (embodiment 13) of the present invention; and
Fig. 29 is a model view showing an essential portion of the transfer molding apparatus according to another embodiment (embodiment 14) of the present invention.

### DESCRIPTION OF THE PREFERRED EMBODIMENTS

Later, the embodiments of the invention will be described in detail with reference to the drawings.

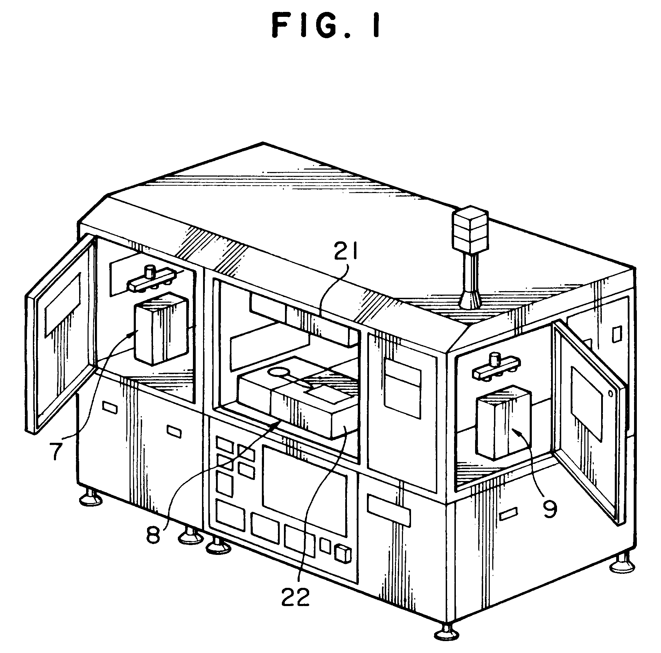

Fig. 1 is a perspective view showing an outer appearance of the overall transfer molding apparatus used for the method for manufacturing a semiconductor integrated circuit device according to the present invention. This apparatus is used for sealing a semiconductor chip of a semiconductor pellet, that is, a lead frame having the semiconductor chip bonded thereon, with resin.

The lead frame having the semiconductor chip bonded thereon is conveyed from a loader 7 to the transfer molding apparatus 8, in which the semiconductor chip is sealed. After the lead frame is packaged with resin, the packaged lead frame is conveyed out and then accommodated by an unloader 9.

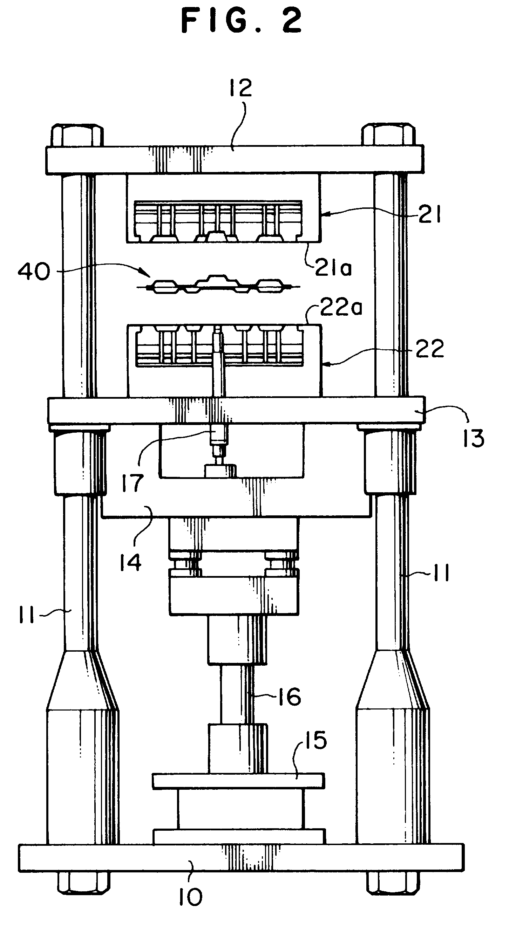

The detailed construction of the transfer molding apparatus 8 will be shown in Fig. 2. A numeral 10 denotes a pedestal. A numeral 11 denotes columns whose lower ends are secured on the pedestal 10. 12 denotes a fixed platen secured on the upper ends of the columns 11. A movable platen 13 is fitted to the columns 11. The movable platen 13 is allowed to be vertically moved as guided by the columns 11. The movable platen 13 provides a driving block 14 secured thereon. The driving block 14 is linked to a rod 16 of a cylinder 15 located on the pedestal 10. The cylinder 15 is operated by oil or air pressure. The movable platen 13 is vertically moved through the effect of the driving block 14 operated by the cylinder 15.

The fixed platen 12 is fixed with an upper unit 21, that is, an upper molding die unit, the die matching face 21a of which is directed downward. On the other hand, a lower unit 22, that is, a lower molding die unit is secured on the movable platen 13. The lower unit 22 has a die matching face 22a directed upward.

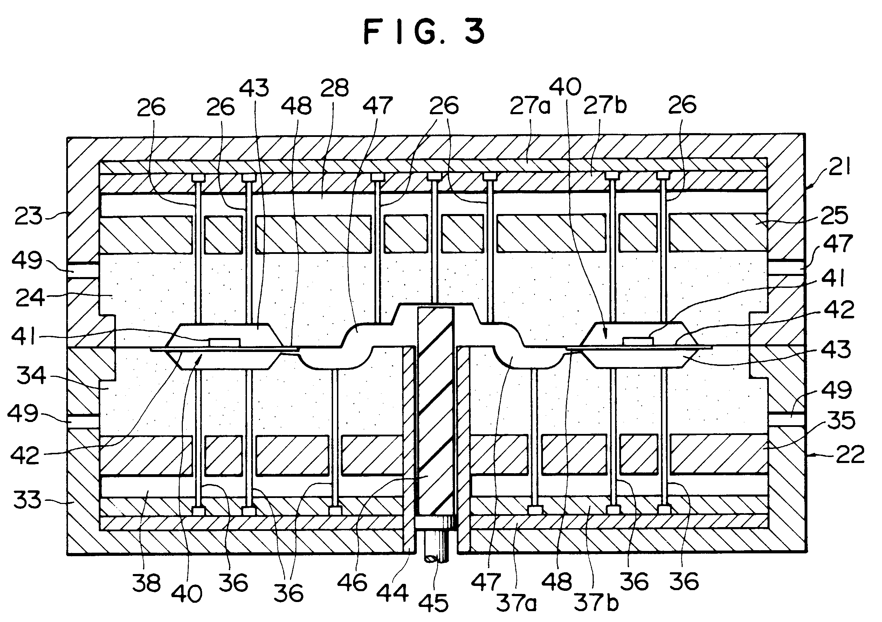

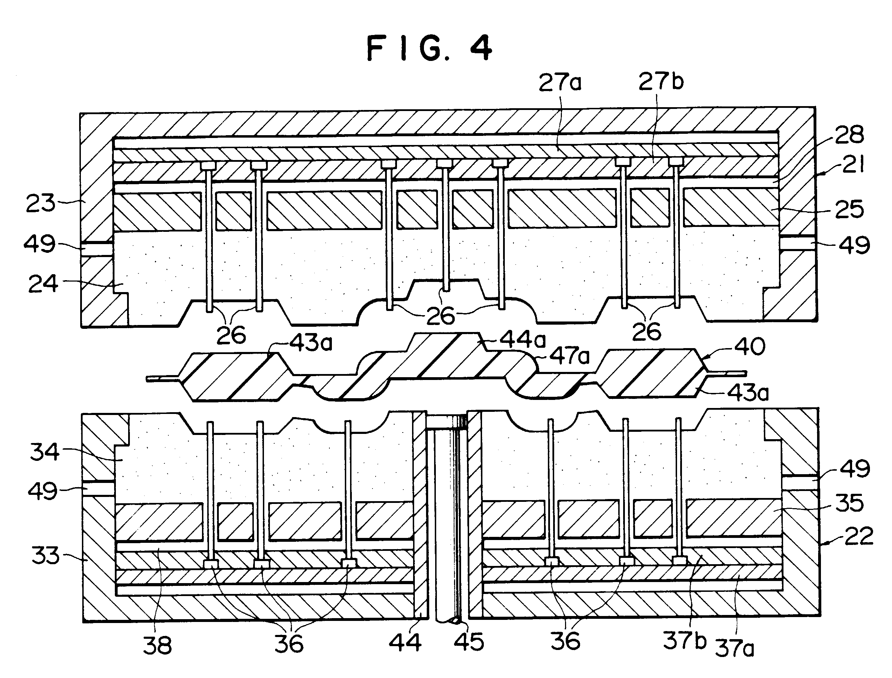

The details of the upper unit 21 and the lower unit 22 will be illustrated in Figs. 3 and 4. The upper unit 21 is made of metal such as steel and has a boxy protecting frame 23 whose lower portion is opened. A numeral 24 denotes a die body served as a first die, which is fitted to the protecting frame 23. A numeral 25 denotes a protecting plate secured on the inside of the die body 24. Plural ejector pins 26 are axially penetrated through the die body 24 and the protecting plate 25. Those ejector pins 26 are allowed to slidably travel therethrough. Each base end of the ejector pins 26 is pressed between a first ejector plate 27a and a second ejector plate 27b secured thereon.

Between the ejector plate 27b and the protecting plate 25, a gap 28 is formed. In the range of the gap 28, the ejector plates 27a and 27b are allowed to vertically move against the die body 24. The vertical action of the ejector plates 27a and 27b leads to that of the ejector pins 26.

Like the upper unit 22, the lower unit 22 is made of metal such as steel. The lower unit 22 has a boxy protecting frame 33 whose top is opened. This protecting frame 33 is fixed to a die body 34 served as a second die. A protecting plate 35 is secured on the inside of the die body 34. Plural ejector pins 36 are penetrated through the die body 34 and the protecting plate 35 axially against them. Those ejector pins 36 are allowed to slidably travel through the die body 34 and the protecting plate 35. The base end of each ejector pin 36 is pressed between a first ejector plate 37a and a second ejector plate 37b secured thereon.

Between the ejector plate 37b and the protecting plate 35, a gap 38 is formed. In the range of the gap 38, the ejector plates 37a and 37b are allowed to vertically travel against the die body 34. The vertical action of the ejector plates 37a and 37b leads to that of the ejector pins 36. These ejector plates 27a, 37b, 37a and 37b are vertically driven by driving means.

On the surface of each die body 24 or 34, concaves portion is formed to correspond to the resin molded portion. Of those concave portions, as shown in Fig. 3, a cavity 43 is the portion corresponding to the portion of the lead frame 42 having a semiconductor chip 41 bonded thereon, that is, the resin sealed portion.

The lower unit 22 contains a hollow cylindrical pot 44 fitted thereto. A plunger 45 is fitted to the inside of the pot 44. This plunger 45 is allowed to axially travel in the pot 44. The plunger 45, as shown in Fig. 2, is driven by a cylinder 17 fitted to the driving block 14. On the tip of the plunger 45 is placed a tablet 46 made of resin. This tablet 46 is heated by heaters located in the die body 24, 34 and the protecting plates 25, 35. The tablet 46 is heated by a pre-heater and then is put into a pot 44 in which the viscosity of resin is made lower.

When the die bodies 24 and 34 are matched, these die bodies 24 and 34 serve to form runners 47 and gates 48 for guiding molten resin from the pot 4 to the cavity 43.

Further, the upper unit 21 or the lower unit 22 may be formed of plural chase blocks having concave portions formed to correspond to the cavities and a center block having the pot 44. Or, the unit may use a multi-pot type having plural pots 44.

Each of the die bodies 23 and 34 is formed of a porous material. Hence, the die body has such ventilation as guiding out the gas left in the spaces such as cavities 43 formed in the die bodies 24 and 34. As the porous material, a sintering material such as metal powder or ceramics powder is used. On the overall surface of the die body 24 or 34, many fine pores each having a length of several µm are formed.

Next, the description will be oriented to the process for manufacturing a semiconductor integrated circuit device. In the pre-die bonding process, the semiconductor chips 41 shown in Fig. 3 are secured on the lead frame 42. An inner lead formed on the lead frame 42 and an electrode formed on a first face of the semiconductor chip 41 are electrically coupled with each other through a wire. This coupling results in forming a chip-lead compound 40.

Then, the solid resin tablet 46 heated by the pre-heater is placed on the plunger 45, and the lead frame 42 is put between both of the die bodies 24 and 34. Figs. 2 to 4 show only two cavities 43 into which resin is supplied from the pot 44 and filled, but the other cavities are formed on each of the die bodies 24 and 34 in the vertical direction of the figures.

In this state, by driving the cylinder 15 shown in Fig. 2, the lower unit 22 is moved closer to the upper unit 21 so that the spaces containing the cavities 43 are defined by the surfaces of the die bodies 24 and 34. When the plunger 45 driven by the cylinder 17 serves to press the molten metal, the molten metal is flown into the cavities 43 through runners 47 and gates 48.

In the process of flowing the molten resin, the gas left in the runners 47 and the cavities 43 are discharged out through the die bodies 24 and 34 that are overall formed to have a ventilating function. To discharge out the gas flown in the die bodies 24 and 34, the protecting frame 23 has an exhaust hole 49 formed therethrough. In addition, the exhaust hole 49 may be connected to sucking means for exhausting the gas flown in the die bodies 24 and 34 out.

After heating and hardening the resin filled in the cavity 43, the cylinder shown in Fig. 2 is driven for lowering the lower unit 22. Both of the dies are opened from each other. Next, the ejector plates 27a and 27b of the upper unit 21 are lowered and the ejector plates 37a and 37b of the lower unit 22 are raised. This movement makes the ejector pins 26 and 36 projected out. This is the termination of the opening of the dies as shown in Fig. 4. Then, the chip-lead compound 40 is released out. Apparently, the compound 40 contains the molded package 43a for sealing the semiconductor chip 41.

As shown in Fig. 4, the sealed chip-lead compound 40 contains packages 43a for the cavities 43, portions 47a for the runners 47, and cull portions 44a that are not filled in the runners 47.

### (Embodiment 2)

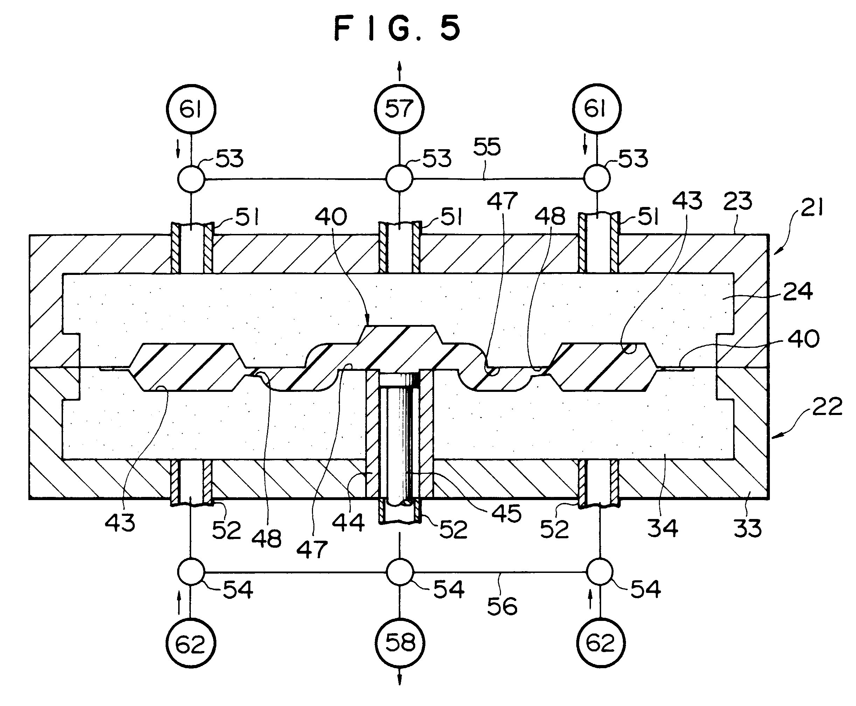

Fig. 5 shows a transfer molding apparatus according to another embodiment of the present invention, in which the common components of this embodiment to those of the foregoing embodiment have the same numerals. In Fig. 5, the transfer molding apparatus does not include an ejector pin and an ejector plate. The upper unit 21 is formed by the protecting frame 23 and the die body 24. The upper unit 23 is formed by the protecting frame 33 and the die body 34. The upper unit 21 is fitted to the fixed platen 12 shown in Fig. 2, while the lower unit 22 is fitted to the movable platen 13 for allowing the vertical action of the unit 22 itself.

The protecting frame 23 has vent pipes 51 fitted thereto. The protecting frame 33 also has vent pipes 52 fitted thereto. Each of the vent pipes 51 is connected to a pipe 55 provided with a change-over valve 53. Likewise, each of the vent pipes 52 is connected to a pipe 56 provided with a change-over valve 56. The pipe 55 is connected to a vacuum pump 57 and a compressor 61. The pipe 56 is connected to a vacuum pump 58 and a compressor 62.

In the molding apparatus shown in Fig. 5, when resin is supplied from the pot 44 to the runner 47 and the gate 48 and then is filled in the cavity 43, vacuum pumps 57 and 58 are driven so that the gas left in the cavity 43 is discharged out through the die bodies 24 and 34. When the dies are opened for releasing the lead frame 42 out of the dies after the molding is terminated, a compressed air is supplied by compressors 61 and 62 to the matched faces of the dies through the ventilating die bodies 24 and 34. Hence, the chip-lead compound 40 is taken out without using the ejector pins unlike the foregoing embodiment. Apparently, the chip-lead compound 40 contains the package 43a for sealing the semiconductor chip 41. At a time, the air jetted to the surfaces of the die bodies 24 and 34 serves to clean the die bodies 24 and 34 themselves and their surfaces.

In the illustrative embodiment, the die bodies 24 and 34 are overall formed of a porous material so that the overall bodies are ventilative. In place, only the portions for the cavities 43 or their parts may be formed of such a porous material. In the figure, though both of the die bodies 24 and 34 are formed of a porous material, only one die body may be formed of a porous material.

### (Embodiment 3)

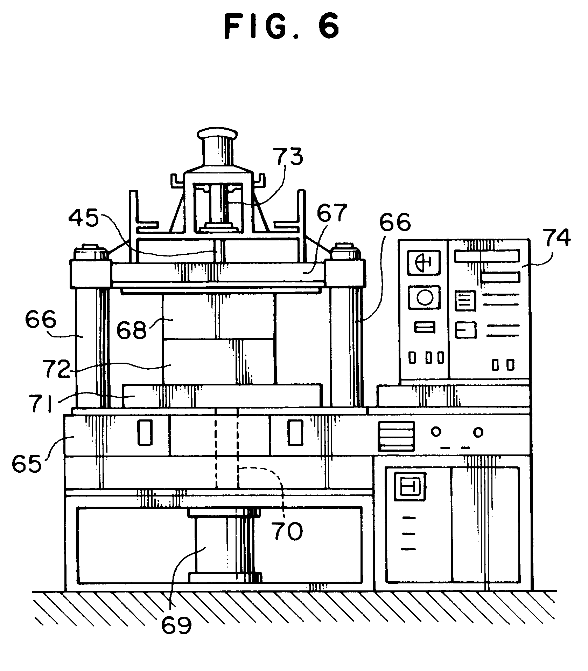

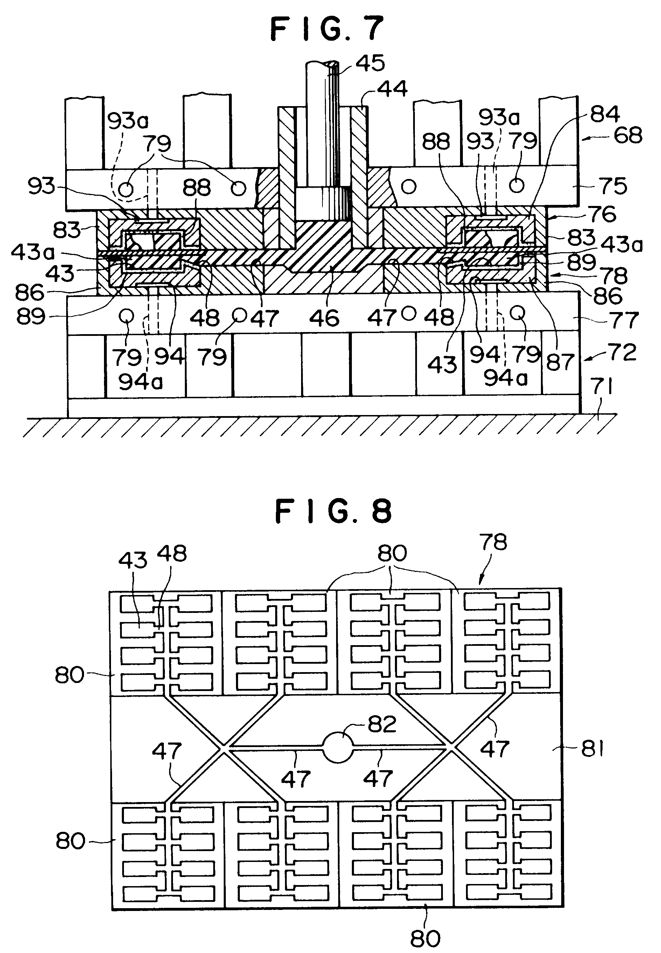

Fig. 6 is a front view showing a transfer molding apparatus according to another embodiment of the present invention. Fig. 7 is a partially cutaway enlarged front view showing an essential portion of the apparatus shown in Fig. 6.

As shown in Fig. 6, the transfer molding apparatus includes plural posts 66 fixed on a pedestal 65. Each post 66 has a stationary platen 67 secured on the top end thereof. The stationary platen 67 is fixed with an upper unit 68. A numeral 71 denotes a movable platen fitted to a rod 70 of a cylinder 69 to be hydraulically operated. The movable platen 71 is fixed with a lower unit 72. A cylinder 73 for driving a plunger 45 is fitted to the stationary platen 67. These cylinders 69 and 73 are controlled by a control unit 74 fixed on the pedestal 65.

Fig. 7 is a view showing the details of the upper unit 68 and the lower unit 72. The upper unit 68 has an upper base member 75 to which an upper die 76 served as a first die is fitted. The lower unit 72 has a lower base member to which a lower die 78 served as a second die is fitted. The lower die 78 is moved closer to or off the upper die 76 in synchronization with the vertical operation of the movable platen 71 caused by the cylinder 69. The matching of both dies 76 and 78 results in forming a cavity 43 for a package 43a made of resin on a die matching face called as a parting face or a mold separating face.

Each of the base members 75 and 77 has a heater 79 built therein, which operates to heat the corresponding die 76 or 78. A numeral 44 denotes a cylindrical pot 44 passing through the upper base member 75. The pot 44 is fitted to the upper die 76. The plunger 45 is fitted inside of the pot 44 so that the plunger 45 may freely slide on the axis of the pot 44. This plunger 45 is driven by the cylinder 73 as shown in Fig. 6. In the pot 44, there is located a tablet 46 made of resin. This tablet 46 is pressed and shifted into the cavity 43 formed on the matching face of the dies 76 and 78.

In order to guide the molten resin to the cavity, a runner 47 for communicating the pot 44 with the cavity 43 is formed on the matching face. The inlet of the runner 47 to the cavity 43 is a gate 48.

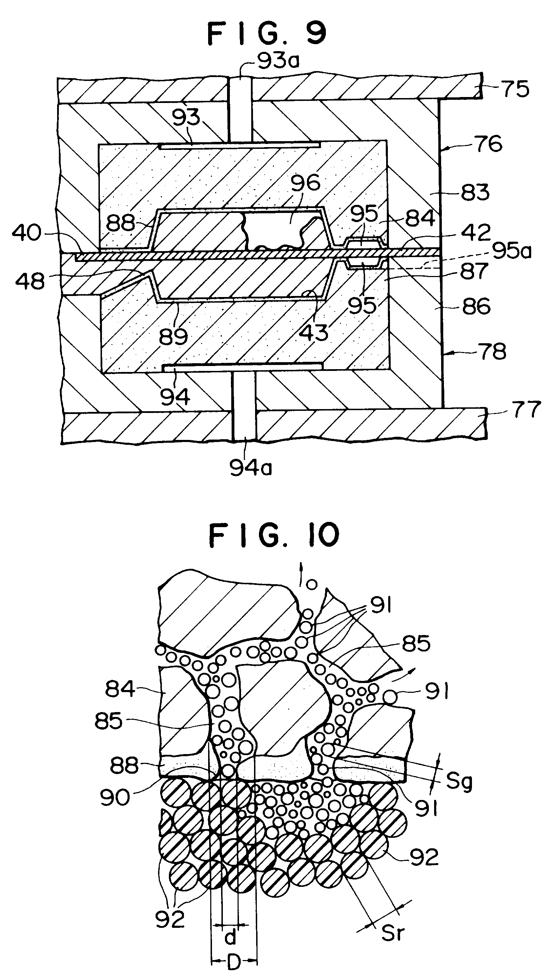

Fig. 8 is a plane view showing the lower die 78. As shown, eight chase blocks 80 and a center block 81 compose the lower die 78. Each chase block has cavities 43 formed for a package 43a. The center block 81 has a runner 47 formed to communicate with each cavity 43. The lower die 78 has a cull space 82 in which cull, that is, resin overflown out of the runner 47, is left. The cull space 82 matches to the pot 44 fitted to the upper die 76.

In the illustrative embodiment, as shown in Fig. 8, the lower die 78 is structured to have eight chase blocks. Any number of chase blocks, for example, four or six chase blocks may be selected if necessary. In Fig. 7, the structure employs a single pot type having a single pot. Two or more pots may be provided.

Fig. 9 is an enlarged section partially showing the upper and the lower dies 76 and 78. The upper die 78 includes a protecting block 83 fitted to the upper base member 75 and a cavity block, that is, a die body 84 for forming the cavity 43 for molding the package 43a, the die body 84 located in the block 83. The die body 84 is formed of a porous material. As shown in Fig. 10, the die body 84 has a porous structure having air vents 85.

The lower die 78 includes a protecting block 86 fitted to the lower base member 77 and a die body 87 for forming a cavity for molding the package 43a, that is, a cavity block, located in the block 86. Like the die body 84, the die body 87 is formed of a porous material. So, the die body 87 employs a porous structure having air vents.

On the surface of each die body 84 or 87, a filter layer 88 or 89 is formed. Each of the filter layers 88 and 89 includes communicating pores 90. Those communicating pores 90 allow only the gas in the space such as the cavity 43 formed between the die bodies to pass through the air vents formed in the die bodies 84 and 87 and disallow the molten resin to pass through the air vents 85. That is, those communicating pores 90 serve to separately discharge the gas out of the die bodies. It means that each of the filter layers 88 and 89 is a kind of membrane.

Fig. 10 is a partially enlarged section showing the die body 84 of the upper die 76 and the filter layer 88 formed on the surface of the die body 84. As described above, the die body 84 is formed of a porous material and has air vents 85, each average opening size of which is D. Each of the communicating pores 90 formed in the filter layer 88, which serves to separately discharge the gas, has an opening size of d. Assuming that Sg is a maximum size of each molecule 91 of gas such as air left in the space such as the cavity 43 formed by matching the upper and the lower dies 76 and 78 with each other and Sr is a size of each molecule 92 of the molten resin, the opening size D of each air vent 85 and the opening size d of each pore 90 formed in the filter layer 88 are set so that the relation of D > Sr > d > Sg is established.

The foregoing relation is ideal. However, the experiment reports that the size relation of D > (Sr ≤ d) > Sg is allowable in addition to the foregoing relation. By setting the range of the size d to a proper one suited for the property of the flow of the resin, it is possible to suppress the intrusion of the resin into the communicating pores 90 formed in the filter layer 88 for obtaining the desired effect. This holds true to the die body 87 of the lower die 78 and the filter layer 89.

Each of the die bodies 84 and 87, as shown in Fig. 9, includes an exhaust space 93 or 94 facing the protecting block 83 or 86. Each of the exhaust spaces 93 and 94 communicated with the outside through an exhaust path 93a or 94a. To prompt the exhaust, a vacuum pump may be connected to each of the exhaust pipes 93a and 94a for sucking the air.

As shown in Fig. 9, the die body 84 or 87 has an exhaust concave portion 95 located outside of the die 76 or 78. On the surface of the exhaust concave portion 95, the filter layers 88 and 89 are also formed. The exhaust concave portion 95 communicates with the outside through an exhaust through ditch 95a formed in the lower die 78. Hence, the gas left in the cavity 43 passes through the filter layers 88 and 89 and then through the air vents 85 formed in the porous material. Then, the gas is flown in the exhaust concave portion 95, and then is exhausted from the exhaust through ditch 95a to the outside. In place, however, to enhance the exhaust performance, the exhaust concave portion 95 may be excluded. Further, the exhaust through ditch 95a may be formed in the upper die 76 or both of the upper and the lower dies 76 and 78.

To manufacture the dies having the filter layers 88 and 89, for example, the die bodies 84 and 87 are formed to have air vents 85 by using sintered metal. Next, when finishing the work of the restricted surfaces of the die bodies 84 and 87 facing the resin material, a more fluidizing material than the mold resin is implanted to the opening for burying a part of an opening of the air vent 85. In place, the same resin as the mold material may be used for molding the product at a higher pressure than a normal mold pressure, for blocking part of an opening of the air vent 85 having a larger size than a constant one and making the diameter of the air vent smaller. This makes it possible to form the filter layers 88 and 89 on the surfaces of the die bodies 88 and 89. By selecting the conditions such as a fluidity and a quality of a burying material, a pressure and a temperature of a molding material, and a time, it is possible to control the lower limit of the size of the opening to be blocked.

Further, in order to prevent a fall of the burying material and adherence to the molding material while the dies are in use, improve the separativeness and the tolerance of the die surface and control the size of the non-blocked opening, it is possible to apply a coat on the overall surface contacting with the burying material and the die molding material by means of various kinds of coating techniques such as Cr planting or TiN. By controlling the thickness of the coat and the coating technique, it is possible to obtain the communicating pores 90 each having a proper size d of its opening.

On the surface of the die body contacting with the resin material, a porous micro filter area made of a thin film is formed to have lots of communicating pores 90 each having a smaller diameter than the inner diameter of the air vent 85 of the die body, that is, the ground material. The micro filter area provides the filter layers 88 and 89 with the function of separating the air left in the die when molding a product or gas generated in the die when molding the product from the resin material. That is, the filter layers are served as separating films.

In turn, the description will be oriented to the process for manufacturing a semiconductor integrated circuit device by the molding apparatus.

A semiconductor chip 41 is mounted on a lead frame 42 in advance. The lead frame 42 has plural inner leads electrically connected with an electrode formed on the first main face of the semiconductor chip 41 with a wire. The resulting lead frame becomes a chip-lead compound 40.

In the state of separating the upper and the lower dies 76 and 78 from each other, the chip-lead compound 40 is located between the dies 76 and 78. Then, the movable platen 71 is lifted up by the cylinder 69 for moving the lower die 78 closer to the upper die 76. This movement allows the spaces containing the mold cavities to be formed on the surfaces of the dies. The chip-lead compound 40 is fixed in the spaces. Then, the solid tablet 46 whose viscosity is made lower by a pre-heater is put into the pot 44, and the tablet 46 molten by the heater 79 is pressed by the plunger 45. As a result, the resin material is flown in the cavity 43 through the runner 47 and the gate 48.

The molten mold resin pressed and shifted in the cavity 43 is flowing in the cavity 43 as the gas such as air left in the cavity 43 is flowing in the air vents 85 formed in the die bodies 84 and 87 through the communicating pores 90 formed in the filter layers 88 and 89.

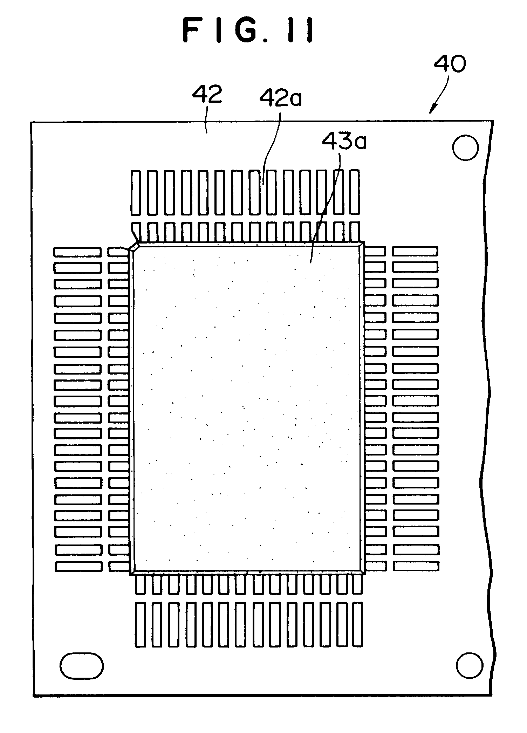

Fig. 9 shows the state in which on the border of the chip-lead compound 40, the resin on the side of the lower die 78 flows faster, hits the end of the cavity 43 in the downstream of the gate 48, passes the gap of the chip-lead compound 40 and flows up to the upper die 76. Gas such as air is left in the empty portion 96 where no molten resin in the upper die 76 is not still flown. However, as the implantation of the resin is advancing, the gas passes through the communicating pore 90 (see Fig. 10) formed in the filter layer 88 around the empty portion 96 and then is discharged out of the upper die 76 through the exhaust space 93 and the exhaust pipe 93a as shown in Fig. 9. The resin is pressed and filled in the cavity 43 in which the resin is heated and hardened. Then, in response to a control signal sent from a control unit 74 shown in Fig. 6, the movable platen 71 is lifted down so that the upper die 76 is separated from the lower die 78. After both dies are off, as shown in Fig. 11, the chip-lead compound 40 is released in which the package 43a is formed of the resin. This release is done by the ejector pins. In place, by supplying compressed air from the exhaust pipes 93a and 94a for injecting air from the communicating pores 90, it is possible to remove the molded chip-lead compound 40.

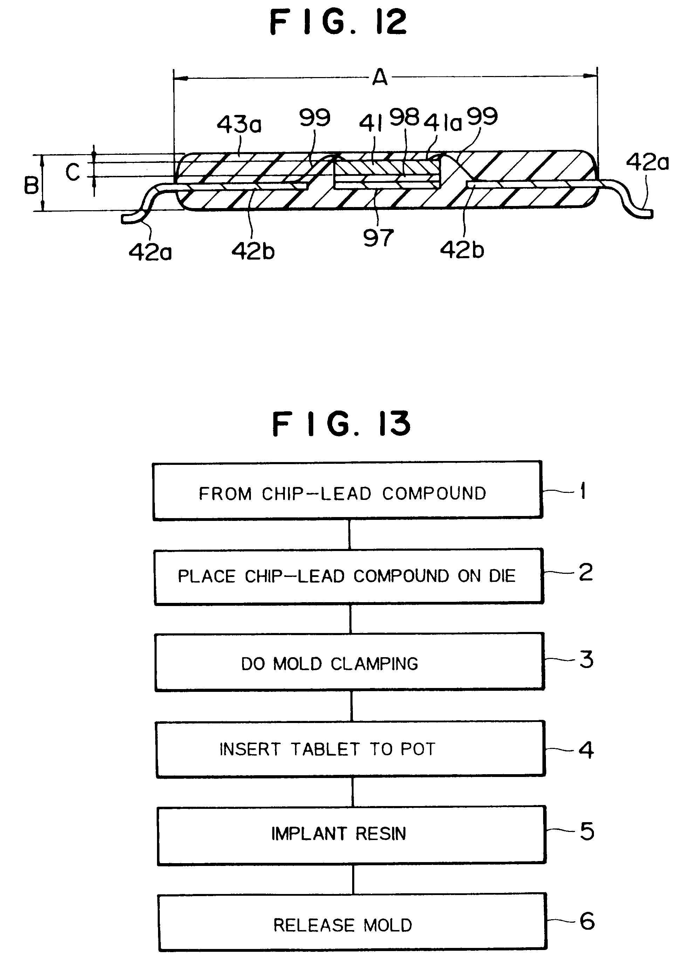

By cutting the outer leads 42a projected from the package 42a and molding them to a predetermined form, the chip-lead compound 40 having the package 43a formed therein is made to be a semiconductor integrated circuit device shown in Fig. 12. In Fig. 12, a numeral 97 denotes a tab, on which a semiconductor chip 41 is pasted through an adhesive material 98 such as sliver paste. The semiconductor chip 41 has the electrode pad 41a and the inner lead 42b, both of which are electrically connected through a conductive wire 99 made of gold (Au) or aluminium (Al). The electric connection makes it possible to apply a supply voltage and do the I/O of a signal from the outside to the semiconductor chip 41 through the outer lead 42a.

The semiconductor integrated circuit device shown in Fig. 12 has a width A of about 10 mm and a thickness B of about 1 mm. Inside of the IC device is sealed the semiconductor chip 41 whose thickness size C is about 0.4 mm. This is a resin-sealed type. Even such a thin type may be manufactured at a high yield without physically transforming it.

Fig. 13 shows a process for manufacturing the foregoing semiconductor integrated circuit device. In a die bonding process, the semiconductor chip 41 is fitted on the tab 97 of the lead frame 42. Next, in the wire bonding process, the electrode pad 41a and the inner lead 42b of the semiconductor chip 41 are electrically connected through the wire 99. Then, the process 1 for forming the chip-lead compound 40 is terminated, in which process the chip-lead compound 40 is prepared.

This chip-lead compound 40 is transferred to the transfer molding apparatus. Then, in the process 2, the compound 40 is placed on the die of the molding apparatus. Next, in the process 3, the dies are matched for mold clamping. After the mold clamping, in the process 4, the tablet 46 is inserted to the pot 44. After the insertion, the plunger 45 starts to press the tablet 46. Then, in the process 5, the resin is implanted. After the implantation, the dies are kept in the mold clamping for a several minutes and then the resin is hardened. In addition, the insertion of the tablet in the process 4 may be executed in advance of the placement of the chip-lead compound 40 on the die.

After the resin is hardened, the separating process 6 is executed and then the chip-lead compound 40 is released from the dies in which compound the package 43a is formed.

### (Embodiment 4)

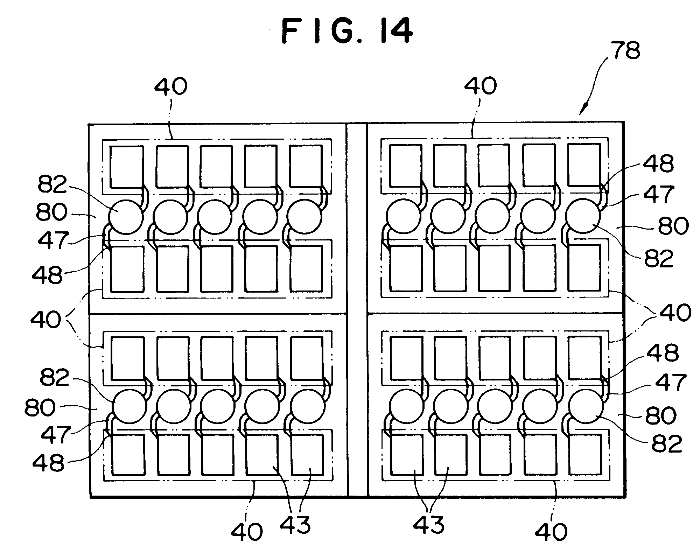

Fig. 14 shows the lower die 78 provided in the transfer molding apparatus according to another embodiment of the present invention, in which the shown portion corresponds to that shown in Fig. 8. In Fig. 14, the components common to those shown in Fig. 8 have the same reference numbers.

This transfer molding apparatus has plural pots. The lower die 78 provides four chase blocks 80, each of which has five cull spaces 82 corresponding to the pots. Each cull space 82 is connected to the concave portions of the two cavities 43 through the runner 47 and the gate 48. Any number of blocks may compose the lower die 78. Each block 80 may any number of cavities 43 formed therein. In Fig. 14, the chip-lead compound 40 placed on the lower die 78 is shown in a two-dot chain line.

As described above, to manufacture the semiconductor integrated circuit device through the effect of a multi-pot type transfer molding apparatus having plural pots 44, the process 4 of inserting the tablet 46 shown in Fig. 13 into the pot 44 is executed before the process 2 of placing the chip-lead compound 40 on the die. The other processes are likewise to the foregoing manufacturing process.

### (Embodiment 5)

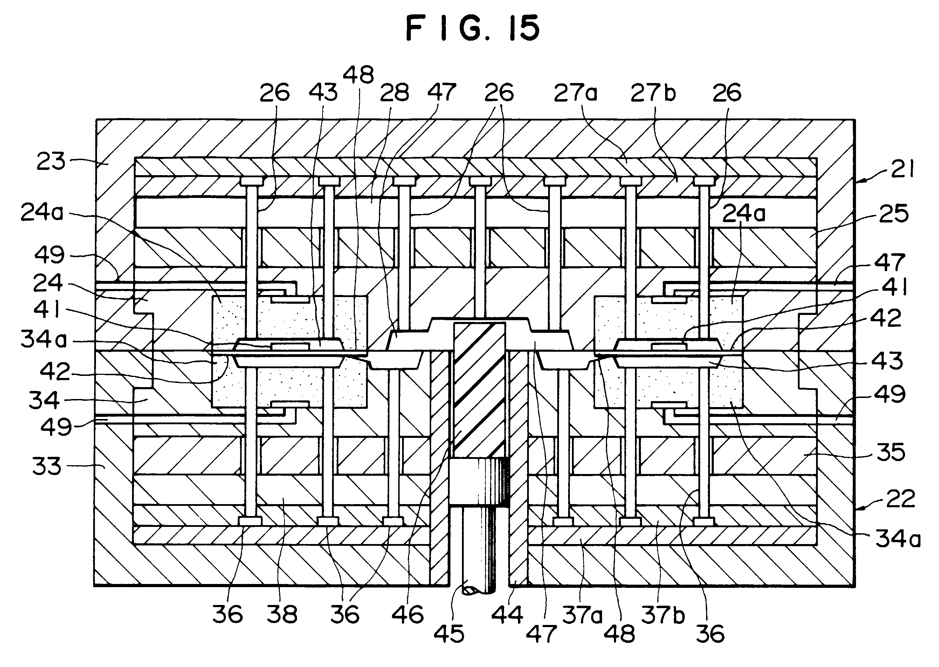

Fig. 15 shows a transformation of the transfer molding apparatus shown in Figs. 3 and 4. In Fig. 15, the components common to those shown in Figs. 3 and 4 have the same reference numbers.

In the transfer molding apparatus shown in Figs. 3 and 4, the corresponding portions of the upper die body 24 and the lower die body 34 to the insides of the cavities 43 and the runners 47 formed for clamping the upper and the lower dies are made of a porous material. In the transfer molding apparatus shown in Fig. 15, the die bodies 24 and 34 each include cavity blocks 24a and 34a for forming one cavity 43, and each of the cavity blocks 24a and 34a is formed of a porous material for making a ventilating portion. The corresponding portions of the die bodies 24 and 34 to the runner 47 are made of steel for the dies.

### (Embodiment 6)

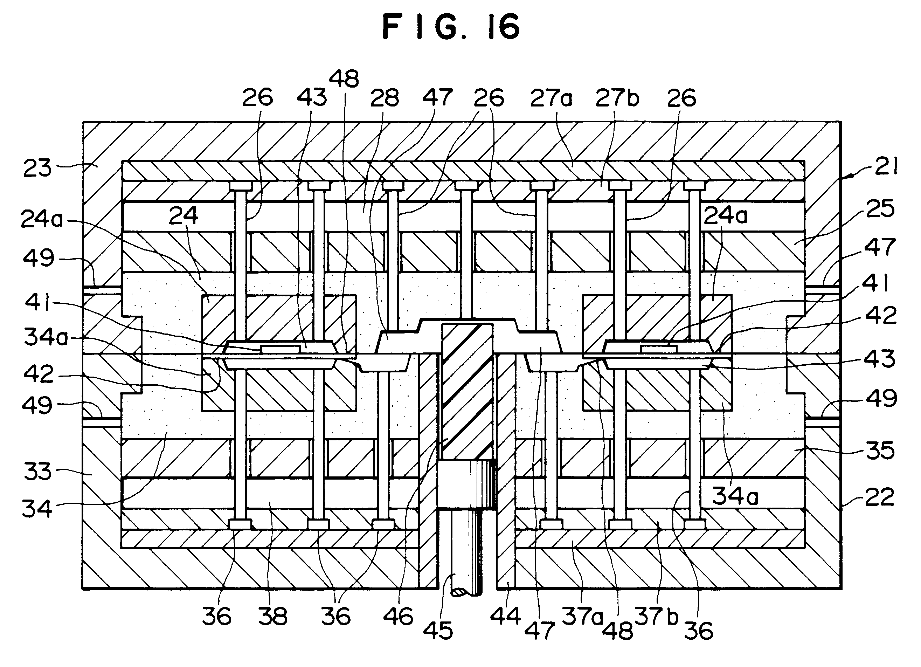

Fig. 16 shows a transformation of the transfer molding apparatus shown in Fig. 15. Each of the cavity blocks 24a and 34a is formed of steel for the die. Hence, those blocks are not ventilative, while the portions corresponding to the runner 47 are formed of a porous material and thus are ventilative. In this case, the pot 44 and the plunger 45 are also formed of a porous material. Hence, when the plunger 45 is pressing the resin tablet 46 so that the resin tablet 46 is filled in the cavity 43 through the runner 47, before the resin reaches the cavity 43, the air or gas left in the pot 44 and the runner 47 are discharged out of the exhaust port 49 through the ventilative pot 44, die bodies 24 and 34 and through the ventilative plunger 45.

In addition, according to this embodiment, air vents (not shown) are provided in the cavity so that air left in the cavity is discharged through the air vents.

### (Embodiment 7)

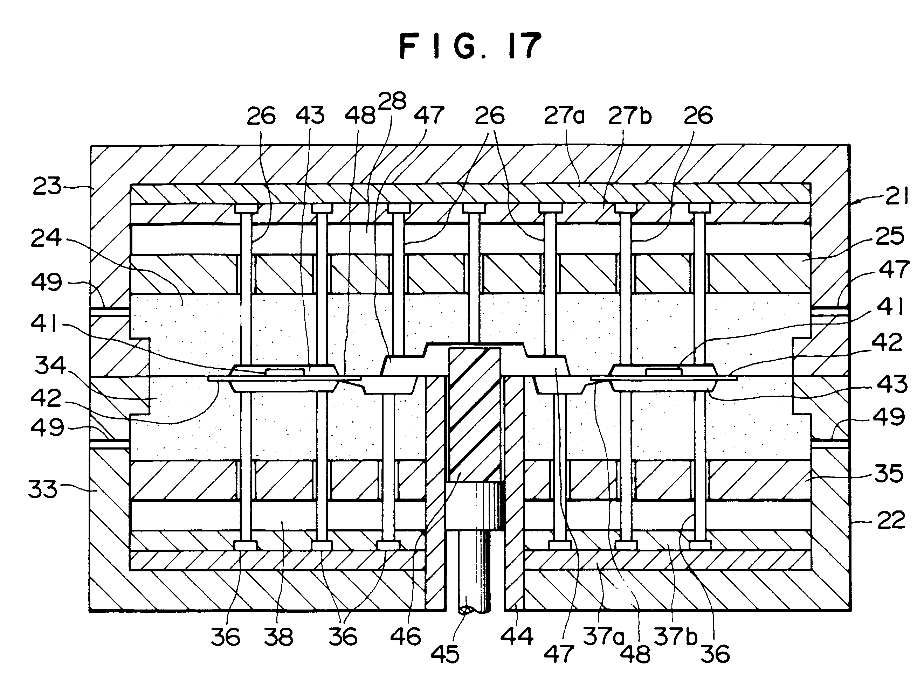

Fig. 17 shows a transformation of the transfer molding apparatus shown in Fig. 16. In the transformation, the die bodies 24 and 34 for forming the cavity 43 and the runner 47, the pot 44, and the plunger 45 are all formed of a porous material. Hence, before the resin reaches the cavity 43, the air or gas left in the pot and the runner 47 is allowed to be discharged out and the air left in the cavity 43 may be discharged out. The plunger 45 shown in Figs. 16 and 17 may have only its tip portion formed of the porous material so that the tip portion may be made ventilative.

In the apparatus shown in Fig. 17, all the cavity 43, the runner 47, the pot 44 and the plunger 45 are formed of a porous material. In place, only the plunger 45 or only the pot 44 may be formed of a porous material.

### (Embodiment 8)

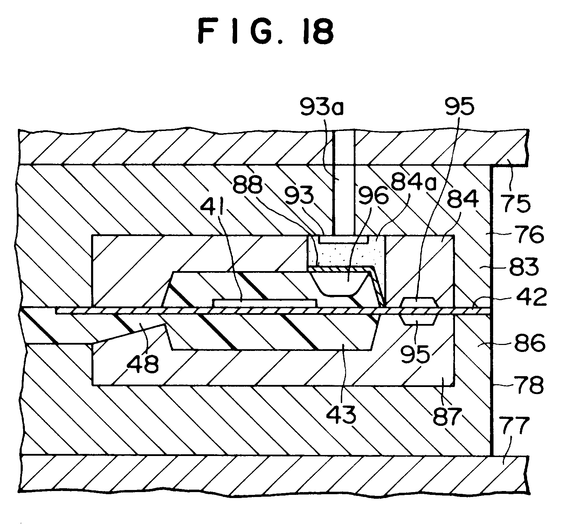

Fig. 18 shows the transfer molding apparatus according to another embodiment of the present invention, in which the portion of the apparatus corresponding to that shown in Fig. 9 is shown. In Fig. 18, the components common to those shown in Fig. 9 have the same reference numbers.

In the transformation, the gate 48 is formed in the die body 87 of the lower die 78. Hence, the resin implanted from the gate 48 to the cavity 43 is located as opposed to the gate 48 and finally filled in the portion corresponding to the upper portion of the cavity 43. In the die body 84 of the upper die 76, a ventilating portion 84a made of a porous material is formed in a manner to correspond to the portion where the resin is finally filled. On the surface of the ventilating portion 84a, the filter layer 88 is formed. This transfer molding apparatus may take the illustrative structure by partially improving the conventional die. If the gate 48 is formed by forming the concave portion in the die body 84 of the upper die, the portion to which the resin is finally filled is located as opposed to the gate 48 and is made to be the portion corresponding to the lower portion of the cavity 43. Hence, it is possible to form the ventilating portion 84a in the die body 87 of the lower die 78 in a manner to correspond to the corresponding portion or form the ventilating portions 84a in each die body of the upper and the lower dies.

### (Embodiment 9)

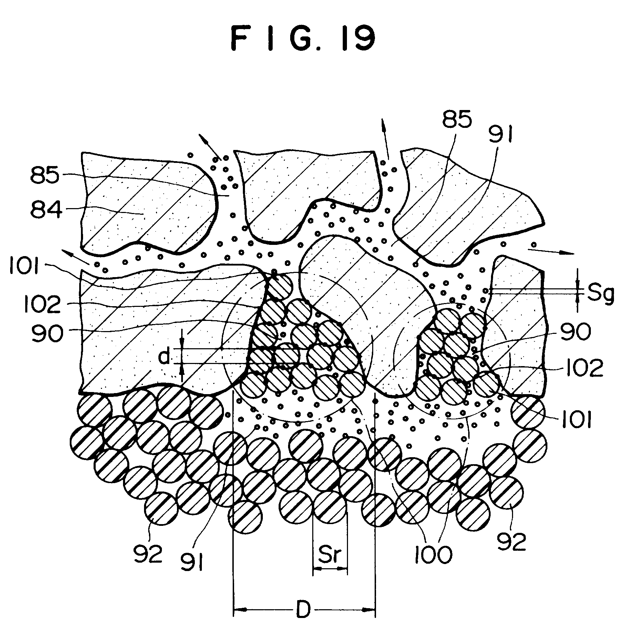

Fig. 19 shows the die body 84 of the upper die 76 provided in the transfer molding apparatus according to another embodiment of the present invention, in particular, the portion of the die body corresponding to that shown in Fig. 10. Like Fig. 10, the die body 84 is formed of a porous material such as sintered metal having metallic or ceramic powder. Hence, the die body 84 has air vents 85 and thus is structured to be porous.

A fine porous portion 100 formed of fine particles 101 coupled by a bonding agent is buried to a predetermined depth from the surface of the die body 84. The fine particles 101 are metallic or ceramic, and the bonding agent 102 may be a wax material to be molten at about 200 to 500°C, for example. The fine porous portion 100 includes communicating pores 90 that communicate with the air vents 85 and have smaller diameters than the air vents 85. This serves to inhibit intrusion of the resin into the die body 84 and allows at least part of gas components to pass through the communicating pores 90 for preventing occurrence of voids in the package 43a.

The air vent 85 has an average inner diameter of about 3 µm or more. Of many communicating pores 85, some may have a larger inner diameter of an opening, for example, about several tens µm or more. If so, since the fine porous portion 100 is buried into each opening of the air vent and extended to a predetermined depth, the fine openings of the communicating pores 90 are formed on the surface of the die body 84. The average inner diameter of the communicating pore 90 is about 2.5 µm or less, or about 0.5 µm or less. The average diameter is selected according to the kind of resin to be used for the mold.

By burying the fine porous portion 100 to a predetermined depth of the air vent 85, it is possible to shorten the gas-passing area of the fine communicating pore 90. Since the air vent 85 has a larger inner diameter than the communicating pore 90, it is possible to keep the ventilation resistance of gas flowing through the die body 84 lower.

The die body 84 of the upper die 76 is shown in Fig. 19. The die body 87 of the lower die 78 is formed in the same manner.

To manufacture the dies 76 and 78 having the fine porous portion 100 as described above, at first, the process is executed to compose the die bodies 84 and 87 from sintered metal so that those die bodies have the air vents 85. Next, when finishing the work of the surface of the restricted portion of each die body 84 or 87 for contacting the resin material, the fine particles 101 made of a proper material to a die material are coupled with one another, and a wax material served as a coupling material 102 is mixed with the fine particles 101 for coupling the fine particles 101 on the inner surface of each communicating pore 85. The mixture is coated on the surface of the die body.

Pressure is applied to the coated mixture so that the mixture is buried into the air vent 85. After removing the extra mixture from the surface, the predetermined process such as heating is executed to couple the fine particles 101 with one another and couple the fine particle 101 with the inner surface of the air vent 85. Along the processes, the fine porous portion 100 is formed inside of the air vent 85. In place, on the surface of the die body 84 or 87, the fine porous portion 100 may be formed.

By selecting a size and a form of the fine particle 101 to be filled in the air vent, a distributing ratio of the fine particle 101 to the coupling material 102, and a way of filling the particles on the surface or inside of the air vent 85, it is possible to control the size of each communicating pore 90 of the fine porous portion 100.

As noted above, the fine porous portion 100 may be a mixture of the fine particles 101 with the grain wax material served as the coupling material 102. Or, it may be possible to apply a coat of the wave material on the surface of the fine particles 101.

As the coupling material 102, it is possible to use a heat-resistant adhesive agent such as an epoxy or polyimide system in place of the wax material. In that case, the adhesive agent is coated on the surfaces of the fine particles 101, and then the coated fine particles 101 or the mixture of the adhesive agent with the fine particles is buried in the air vents 85.

Without the coupling material 102, the fine porous portion 100 may be formed of only the fine particles 101. In this case, after the fine particles 101 are filled in the air vents 85, the fine particles 101 are heated up to around a melting point for melting and coupling the fine particles 101 with one another and the fine particles 101 with the inner surfaces of the air vents 85. The melting and coupling results in forming the fine porous portion 100.

As another method for forming the fine porous portion 100 without the coupling material 102, it is possible to use the fine particles 101 having a larger thermal expansion coefficient than a mother material of the die body 84 or 87. In this case, after the fine particles 101 are filled in the air vents 85 at a low temperature, then, the temperature of those particles is returned to a normal temperature, so that the fine particles 101 are coupled through the effect of the thermal stress caused by the difference between the thermal expansion coefficients, for composing the fine porous portion 100. This type of fine porous portion 100 are expanded by the heat of the mold resin, and when the dies are in use, the coupling force of the fine particles 101 is made stronger.

As another method for forming the fine porous portion 100, it is possible to use a mixture of a grain vaporizing material that is to be sublimed or vaporized at a predetermined temperature with a burying material, that is, the fine porous portion 100 formed by solidifying or hardening the grain vaporizing material at a lower temperature or at the substantially same temperature. In this case, after this mixture is filled in the air vents 85, the mixture is heated up to the subliming or vaporizing temperature. At that time, when or before the grain vaporizing material is vaporized, the burying material is hardened. The resulting fine porous portion 100 is formed of the burying material and has voids corresponding to the volumes of the vaporizing material.

In place of the vaporizing particles, it is possible to use a mixture of a foaming material with a coupling material for forming the fine porous portion 100. When heating the foaming material, fine foams are generated from the foaming material. In this case, after the mixture is filled in the air vent 85, the mixture is heated for generating many foams. Hence, the resulting fine porous portion 100 is formed of only the fine grain coupling material and has the communicating pores corresponding to the foams generated in the foaming material.

Further, as another fine porous portion 100, a highly elastic material such as rubber may be used for the coupling material 102. In this case, the fine porous portion 100 is transformed by the pressure applied by the resin when molding the package. That is, the pressure serves to shrink the communicating pores 90. This automatically prevents intrusion of more than a constant amount of mold resin into the air vents 85. When the molding process advances to a predetermined stage or the molding is terminated, the state of the communicating pores 90 are returned to the original one by the force of elasticity, that is, the communicating pores 90 are made larger. This serves to reduce the ventilation resistance against the gas when the gas is supplied from the outside for separating the chip-lead compound 40 from the dies.

### (Embodiment 10)

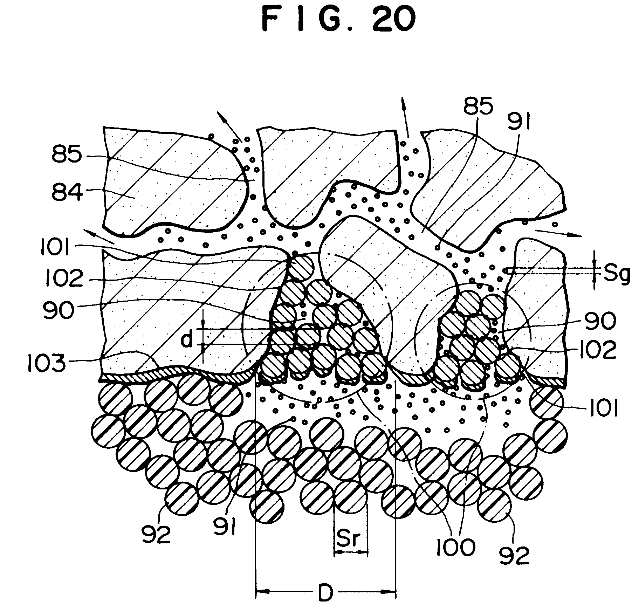

Fig. 20 shows a transformation of the transfer molding apparatus, in particular, the portion of the apparatus corresponding to that shown in Fig. 19. A coating layer 103 is formed on the surface of the die body 84. This coating layer 103 is formed on the surface of the die body 84 as shown in Fig. 19 by means of the plating or vacuum vaporizing means. For the coating, it is possible to use various kinds of surface coating methods such as Cr or Tin Plating. By controlling the coat thickness and the coating method, it is possible to set the size d of the opening of the communicating pore 90 to the most approximate value. Further, by forming the coating layer 103 as described above, it is possible to stubbornly fix the fine porous portion 100 inside of the air vent 85.

Moreover, since the coating layer 103 is formed, it is possible to form the fine porous portion 100 of only the fine particles 101 without using the coupling agent 102 such as a wax material served as the fine porous portion 100. Further, without melting and coupling the fine particles 101 with one another, it is possible to prevent the fall of the particles of fine porous portion 100 from the air vent 85.

The filter layer 88 shown in Fig. 10 may be formed on the surface of the porous material included in the transfer molding apparatus as shown in Figs. 3 to 5 or 15 to 17. Or, as shown in Figs. 19 to 20, the fine porous portion 100 may be formed on the surface.

As noted above, the invention of the present inventors has been concretely described along the preferred embodiments. The present invention is not limited by the foregoing embodiments. It goes without saying that various kinds of transformations and changes of the invention are made possible unless they depart from the spirit of the invention.

For example, the illustrative lead frame 42 provides the tab 97. In place, another kind of lead frame may be formed to have no lead frame. In this lead frame, the semiconductor chip 41 is laminated on the inner lead 42b so that the second face, that is, the face having no circuit of the semiconductor chip 41 is opposed to the inner lead 42b. The electrode pad 41a formed on the first face is electrically connected to the inner lead 42b through a wire 99. The resulting compound is made to be a COL (Chip On Lead) type semiconductor integrated circuit device. On the contrary, the semiconductor chip 41 is laminated on the inner lead 42b so that the first face, that is, the face having a circuit formed thereon of the semiconductor chip 41 is opposed to the inner lead 42b. The inner lead 42b is directly connected to the electrode formed on the semiconductor chip 41 through a solder electrode. The resulting compound is made to be an LOC (Lead On Chip) type semiconductor integrated circuit device.

The illustrative chip-lead compound 40 provides the lead frame 42. In place of the lead frame 42, the chip-lead compound may use a thin film wiring sheet.

The illustrative transfer molding apparatus is constructed so that the lower die may move to or off the upper die by vertically moving the lower die. In place, the lower die may be fixed and the upper die may be vertically moved. Moreover, both of the dies are allowed to be horizontally moved to or off each other.

In the foregoing description, the inventions designed mainly by the present inventors have been applied to the manufacture of a QFP type semiconductor integrated circuit device. However, the present invention is not limited to it. The invention may apply to the manufacture of a DIP (Dual In-Line Package) type semiconductor integrated circuit device, a PLCC (Plastic Leaded Chip Carrier) type or an SOJ (Small Outline J-Leaded Package) type semiconductor integrated circuit device, the latter two of which are sealed by the resin.

Of the inventions disclosed in the present application, the representative inventions provide the following effects.

(1) It is possible to manufacture a high-quality semiconductor integrated circuit device having a sealing portion with no foam and sink.
(2) When manufacturing the semiconductor integrated circuit device, it is possible to prevent occurrence of any resin flash on the sealing portion or transformation of a lead portion caused by the undesired flash in the process of cutting the lead frame or bending the outer lead.
(3) Since the mold is released without using the ejector pins after the sealing portion is molded, the transformation of the sealing portion is prevented in releasing the mold. Further, in the manufacture of a thin semiconductor integrated circuit device, its yield may be high.

### (Embodiment 11)

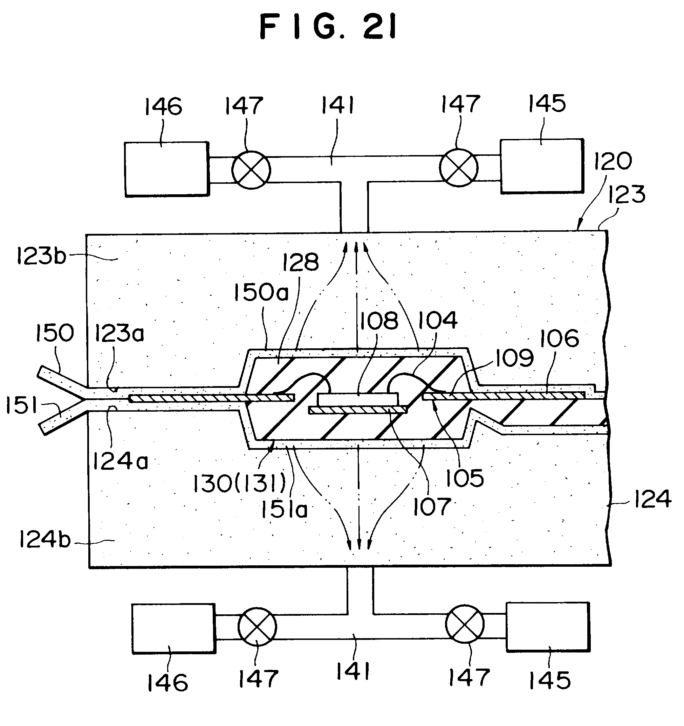

In turn, the description will be oriented to a transfer molding apparatus according to another embodiment of the invention with reference to Figs. 21 to 29.

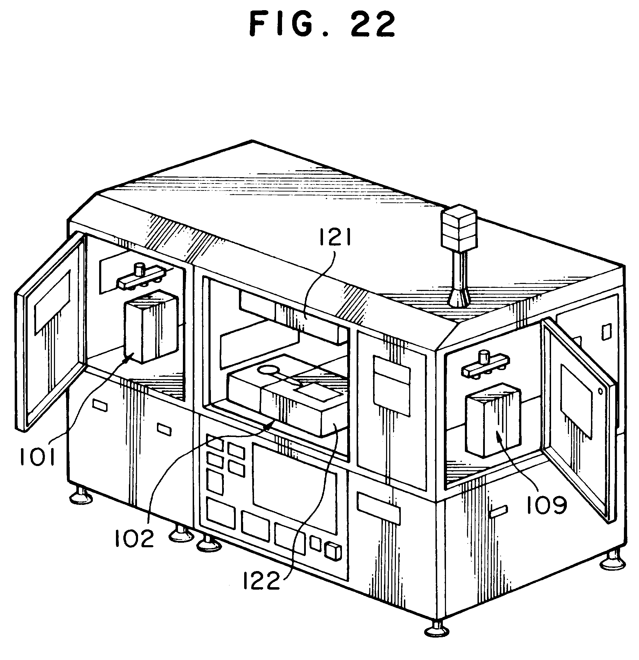

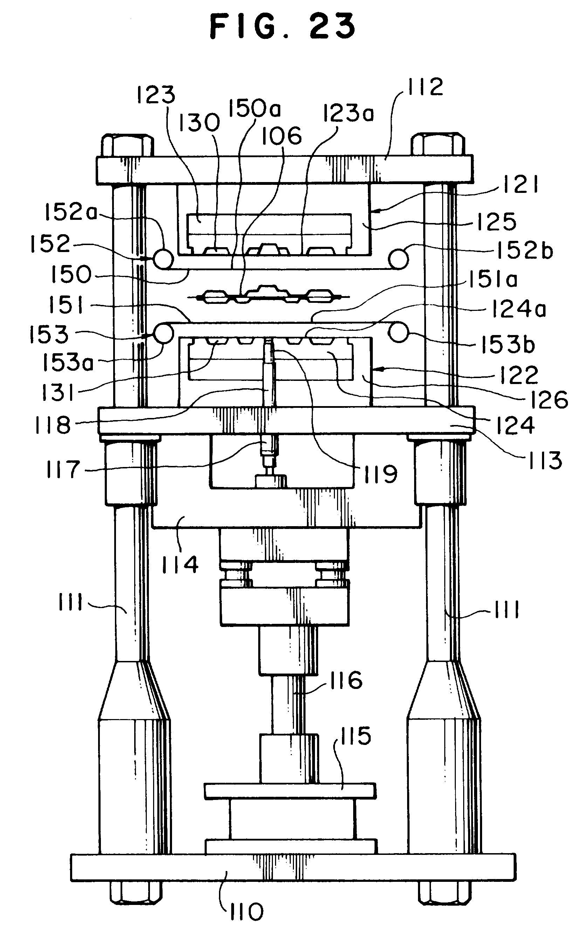

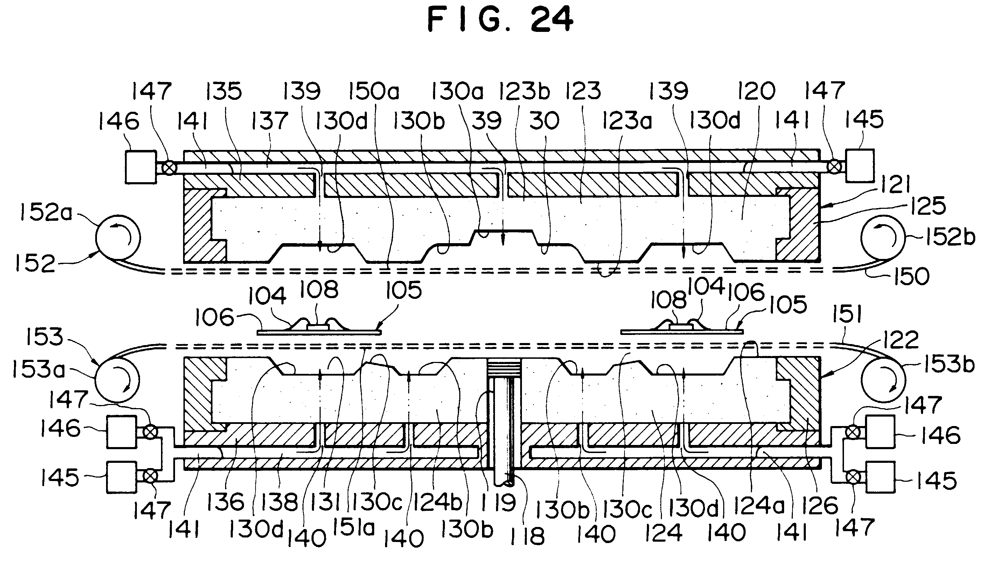

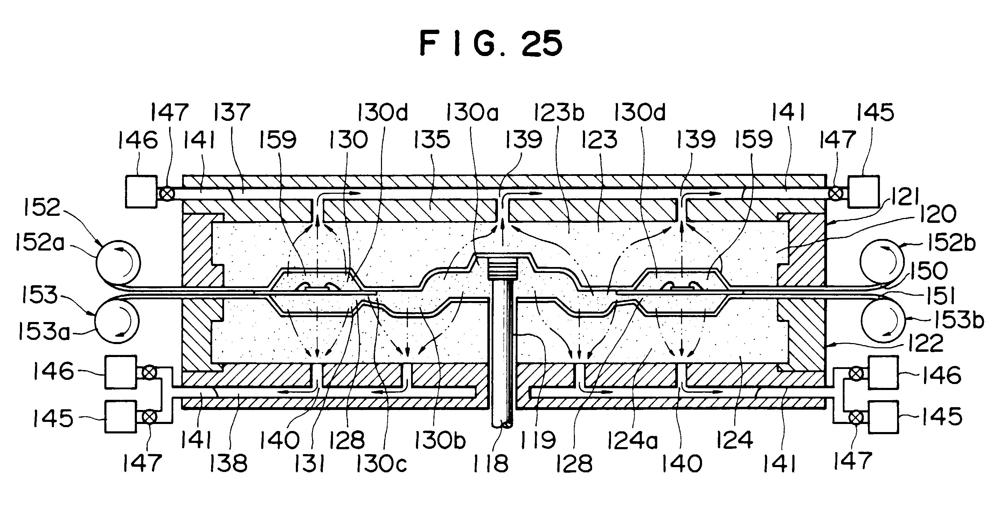

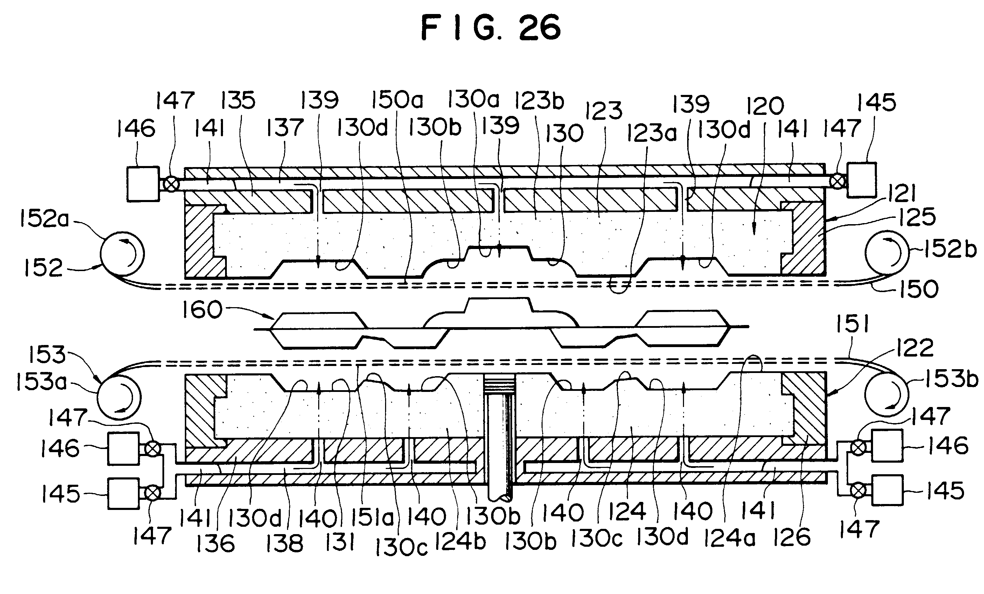

Fig. 21 is a model view showing an essential portion of the transfer molding apparatus according to an embodiment of the present invention (embodiment 11). Fig. 22 is a perspective view showing an outer appearance of the transfer molding apparatus. Fig. 23 is a partially cutaway plane view showing a molding section of the transfer molding apparatus. Fig. 24 is a schematic section showing the opened dies. Fig. 25 is a schematic section showing the dies stays in the molding state. Fig. 26 is a schematic view showing the opened dies.

According to the embodiment 11, the description will be oriented to the resin mold executed by the transfer molding apparatus, for manufacturing the semiconductor device. The transfer molding apparatus, as shown in Fig. 21, is constructed so that a material 105 to be molded is located between the parting face 123a of the upper die 123 and the parting face 124a of the lower die 124 of the die 120 for molding the resin. The material 105 to be molded is structured so that a semiconductor chip 108 is fixed on a supporting plate (tab) 107 of a lead frame 106 and an inner end of a lead 109 is connected to an electrode (not shown) of the semiconductor chip 108 through a conductive wire 104. The semiconductor chip 108, the wire 104 and the inner portion of the lead 109 are sealed by the resin. That is, the material 105 to be molded, as shown in Fig. 22, is transferred from a loader 101 to a molding section (resin molding section) 102, in which the mold is executed. Then, the molded product is transferred out to the unloader 103 in which the molded product is held. In Fig. 21, a numeral 121 denotes an upper unit. A numeral 122 denotes a lower unit.

The resin molding section 102, as shown in Fig. 23, is constructed so that plural guide posts 111 are vertically fixed on a pedestal 110 and each of the guide posts 111 provides a stationary platen 112 fixed on the upper end. The guide post 111 provides a movable platen 113 to be vertically moved. The movable platen 113 provides a driving block 114 fixed on the lower end. The driving block 114 is supported by a rod 116 of a press jack 115 fixed on the pedestal 110 to be operated by oil or air pressure. The driving block 114 is lifted up and down in synchronization to the vertical movement of the rod 116. Hence, the operation of the press jack 115 allows the movable platen 113 to be lifted up and down.

The upper unit 121 is fixed on the lower surface of the stationary platen 112. The lower unit 122 is fixed on the upper surface of the movable platen 113. The upper unit 121 is fitted to the upper die 123. The lower unit 122 is fitted to the lower die 124. As shown in Fig. 24, the upper and the lower dies 123 and 124 are fixed on the protecting frames 125 and 126 of the upper and the lower units 121 and 122, respectively.

The parting face 123a of the upper die 123 is opposed to the parting face 124a of the lower die 124. Those parting faces 123a and 124a provide resin press-fitting portions 130 and 131, respectively. The resin press-fitting portion is concave and includes the cull 130a, the runner 130b, the gate 130c and the cavity 130d. These upper and lower dies 123 and 124 do not provide an over-runners, dummy cavities, air vents, and flow cavities as well as ejector pins. Hence, the die 120 has a simple structure, so that the design of the die 120 may be easier and the manufacturing time of the die 120 may be made shorter.

Further, as shown in Fig. 23, the driving block 114 provides a transfer jack 117 fitted thereon. The transfer jack 117 has a piston rod 118, which is entered into a pot 119 located in the lower unit 122 for pressing a resin tablet put in the pot 119. By pressing the resin tablet, as shown in Fig. 25, molten resin 128 is flown into the cavity 130d through the cull 130a, the runner 130b and the gate 130c.

The upper die 123 is formed of a porous material through which gas such as air is allowed to pass, so the upper die 123 includes a ventilating portion 123b (base ventilating portion). So is the lower die 124. Hence, the lower die 124 includes a ventilating portion 124b (base ventilating portion). The porous material is formed by sintering metal powder or ceramic powder. These ventilating portions 123b and 124b include communicating pores whose diameter is 1 µm to several µm, through which air is allowed to freely pass.

On the back sides of the upper and the lower units 121 and 122, there are fixed flow path blocks 135 and 136. The flow path block 135 provides flow paths extending horizontally and communicated with each other. So is the flow path block 136. On the face of the flow path block 135 contacting with the upper die 123, lots of communicating pores 139 are provided. Likewise, on the face of the flow path block 135 contacting with the lower die 124, lots of communicating pores 140 are provided. The communicating pores 139 and 140 communicate with the flow paths 137 and 138. Hence, gas is allowed to pass through the ventilating portions 123b and 124b and the flow paths 137 and 138.

Each of the flow paths 137 and 138 is connected to plural communicating pipes 141. Each communicating pipe 141 is connected to a vacuum pump 145 served as sucking means or a compressor 146 served as means for supplying compressed gas. For the lower unit 122, the communicating pipe 141 is branched into branch pipes, each tip of which is connected to the vacuum pump 145 or the compressor 146. The communicating pipe 141 provides a valve 147 at a predetermined spot, which valve is to be automatically shut or opened.

The switching of the valve 147 and the driving of the vacuum pump 145 serve to discharge (suck) the air left in the resin press-fitting portions 130 and 131 of the upper and the lower dies 123 and 124. The switching of the valve 147 and the driving of the compressor 146 serve to supply compressed air to the resin press-fitting portions 130 and 131 for pushing out a mold fitted in the resin press-fitting portions 130 and 131 through the effect of the pressure of the compressed air. Fig. 21 is a conceptual section showing the embodiment 11, in which the flow path blocks 135 and 136 are removed and each component is simplified.

As shown in Fig. 24, between the parting faces 123a of the upper die 123 and the parting face 124a of the lower die 124, two extensible porous films 150 and 151 are stretched. The porous films 150 and 151 have ventilating portions (surface ventilating portion) 150a and 151a through which air is allowed to pass. Each air vent of the ventilating portions 150a and 151a has a larger diameter than that of the ventilating portions 123b and 124b of the upper and the lower dies 123 and 124. Concretely, the former air vent has a diameter of about 0.1 to 1 µm. This embodiment 11 selects a diameter of 0.5 µm. The minimum grain diameter of the molten resin for molding a semiconductor device is about 1 µm. Further, as the porous films 150 and 151, heat-resistant films are selected so that those films are allowed to resist the heat appearing in molding the semiconductor device. For example, it may use tetrafloroethylene resin film that covers the temperature range from - 120 to 260°C. The porous films 150 and 151 are as thin as 300 µm or less, because these films have to be transformable.

The porous film 151 extending on the lower die 124 has a pore corresponding to the pot 119. As such, the molten resin in the pot 119 is flown into the cull 130a, the runner 130b and the gate 130c and then is filled in the cavity 130d.

The porous films 150 and 151 are formed like a long tape and has the substantially same width as the upper and the lower dies 123 and 124. Those films extend on the overall areas of the parting faces 123a and 124a of the upper and the lower dies 123 and 124. The porous films 150 and 151, as shown in Figs. 23 and 24, are sequentially fed between the parting faces 123a and 124a through the effect of the porous film feeding mechanisms 152 and 153. That is, the porous film feeding mechanisms 152 and 153 are constructed to have feed rolls 152a and 153a around which the films 150 and 151 are wound, take-up rolls 152b and 153b around which the films being fed are wound, and a driving section (not shown) for rotating the feed rolls 152a and 152b, respectively. The feed roll 152a or 153a and the take-up roll 152b or 153b are located on both side of the upper die 123 or the lower die 124.

Hence, the porous films 150 and 151 being fed from the feed rolls 152a and 153a extend between the parting face 123a of the upper die 123 and the parting face 124a of the lower die 124 and then are taken up around the take-up rolls 152b and 153b, respectively.

The ventilating portions 123b, 124b and 150a, 151a compose a two-stage ventilating portion.

In turn, the description will be oriented to a method for manufacturing a semiconductor device through the effect of the transfer molding apparatus as described above.

As shown in Fig. 24, when the upper die 123 is off the lower die 124, that is, both of the dies stay in the mold opening state, the valve 147 is controlled so that the upper and the lower dies 123 and 124 are entered into the sucking discharge state, the vacuum pump 145 are operated, and the porous films 150 and 151 are made in close contact with the surfaces of the resin press-fitting portions 130 and 131. Then, the semiconductor chip 108 is fixed on the lead frame 106. Next, the material 105 to be molded in which the electrode and the wire of the semiconductor chip 108 are electrically connected with the wire is transferred onto the parting face 124a of the lower die 124. Fig. 24 shows the material 105 to be molded is floated. In actual, the material 105 is placed on the porous film 151. The porous films 150 and 151 remain before transformation.

Next, after the preliminary heated resin table is put into the pot 119, as shown in Fig. 25, the lower unit 122 is lifted up for mold clamping. Then, the transfer jack 117 is operated so that the piston rod 18 serves to press the resin tablet. The press makes the resin tablet molten. The molten tablet is flowing through the cull 130a, the runner 130b, and the gate 130c into the cavity 130.

In this process, the air left in the resin press-fitting portions 130 and 131 are sucked by the vacuum pump 145. The sucked air is put into the ventilating portions 150a and 151a of the porous films 150 and 151 and the ventilating portions 123b and 124b of the upper and the lower dies 123 and 124 and then enters into the communicating pores 139 and 140. Next, the air is discharged out of the die 120 through the communicating pipe 141. Hence, the air left in the resin press-fitting portions 130 and 131 such as the cavity 130b are smoothly discharged out by the vacuum pump without bringing about any disturbance. Hence, the air is not entrained in the resin 128 filled in the cavity 130b. It means that no void is generated in the mold (package) 159.

If any spot exists where the porous films 150 and 151 is not contact with the wall surface of the cavity 130d, the implanting press of the resin 128 serves to make the porous films 150 and 151 be in close contact with the wall surface of the cavity 130d. The resulting mold is made to be a complete one with no impairment of its outer appearance.

When the resin implantation is terminated, the vacuum pump 145 is stopped. The valve 147 is automatically switched by a proper means (not shown) so that the ventilating portion is made to be in the state of supplying the compressed gas.

Next, when the hardening of the resin 128 is terminated, as shown in Fig. 26, the dies are opened. At this time, the compressor 146 is operated so that the compressed air is fed into the resin press-fitting portions 130 and 131. The pressure of the compressed air and the restoring force of the porous films 150 and 151 caused by the drawing of the take-up rolls 152b and 153b serve to push the mold 160 out of the resin press-fitting portions 130 and 131. This push-out is made possible only by the compressed air or the restoring force of the films 150 and 151. However, both of the compressed air and the restoring force, that is, the levelling force make the push-out more secure.

When the molded product 160 is conveyed out of the porous film 151, the porous film feeding mechanisms 152 and 153 starts to rotate the rolls so that a new portion of each film is located between the parting face 123a of the upper die 123 and the parting face 124a of the lower die 124. This way of use makes it possible to implement the molding process without any clogging.

The transfer molding method and apparatus according to the embodiment 11 provide the following effects.

(1) The upper die 123 and the lower die 124 include two-stage ventilating portions 123b, 124b, 150a, 151a for guiding the air left in the resin press-fitting portions (such as a cavity) 130, 131 out of the die 120. Hence, it is not necessary to provide a slot air vent on the parting face 123a of the upper die 123 and the parting face 124a of the lower die 124.
(2) The effect (1) makes it possible to prevent any flaw or defective transformation of an outer lead caused by the undesired resin hardened in the air vent.
(3) The effect (1) makes it possible to remove any air vent or the like on the parting face 23a of the upper die 23 and the parting face 24a of the lower die 24, thereby eliminating a de-flashing work for removing the leaked resin.
(4) The effect (1) makes it unnecessary to provide any air vent. It mens that no resin clogging takes place in the air vent. Hence, the resin is fully filled in the cavity 130d and no foam (void) and sink take place on the mold (package) 159. As a result, it is possible to keep the quality of the mold (semiconductor device) constant.
(5) The dies include the two-stage ventilating portions 123b, 124b, 150a, 151a for guiding the air left in the resin press-fitting portions 130 and 131 out of the die 120. It is therefore unnecessary to provide the over-runner, the dummy cavity, the air vent, the flow cavity, and the like for preventing occurrence of any void. This results in making the design of the die easier and the reduction of the die possible.
(6) The ventilating portions 123b, 124b, 150a, 151a are having base ventilating portions (ventilating portions 123b and 124b) and surface ventilating portions (ventilating portions 150a and 151a). The air vent formed in the surface ventilating portions contacting with the molten metal 128 are smaller than the air vents formed in the base ventilating portions. Hence, no clogging takes place in the base ventilating portions.
(7) The surface ventilating portions are exchangeable. It may be exchanged for each mold. Hence, it is possible to prevent occurrence of a defective mold resulting from the resin clogging.
(8) The surface ventilating portions are formed by transforming the extensible porous films 150 and 151 stretched along the parting face 123a of the upper die 123 and the parting face 124a of the lower die 124 through the effect of the suction for discharge (and the resin pressure). Hence, the resulting mold is made to be a proper one with no impairment of its outer appearance.
(9) The surface ventilating portions are formed by the extensible porous films 150 and 151 stretched on the parting face 123a of the upper die 123 and the parting face 124a of the lower die 124. When opening the die 120, therefore, the restoring force, that is, the flattening force of the porous film allows the molded product to be released from the upper and the lower dies. These films may be a substitution of the ejector pins.
(10) The effect (9) makes it unnecessary to provide the ejector pins, so that the die structure is simplified. Hence, the design and the manufacture of the die is made easier, and the reduction of the manufacturing time and cost is made possible.
(11) For each mold process, the porous films 150 and 151 are fed between the parting face 123a of the upper die 123 and the parting face 124a of the lower die 124 through the effect of the porous film feeding mechanisms 152 and 153. Hence, no clogging takes place in the surface ventilating portions. The resulting mold is made to be a proper one with no impairment of its outer appearance.
(12) Since the sucking means communicating with the ventilating portions is operated when the resin is pressed, the air left in the resin press-fitting portions is swiftly discharged out. Hence, the resulting mold is made to be a proper mold with no impairment of its outer appearance and no void. This makes great contribution to improving the yield.
(13) The compressed air supplying means that communicates with the ventilating portions is operated when opening the dies so that the mold 159 is pushed out of the upper and the lower dies by the compressed air. Hence, the mold release of the mold (package) is made secure.
(14) When the mold opening is done, the molded product is taken out of the upper and the lower dies 123 and 124 through the effect of the restoring force of the porous films and the compressed gas supplying means. No ejector pin, therefore, is required. This results in disallowing the ejector pins to prick the mold, thereby being able to preventing occurrence of a chip crack or a package slit.
(15) When designing the die, it is not necessary to provide any over-runner, dummy cavity, air vent, flow cavity and the like as well as any ejector pin, so the die structure is simplified. Hence, the design and the manufacture of the die is made easier, and thus the reduction of the manufacturing time and cost is made possible. In addition, the die is reduced in size.

### (Embodiment 12)

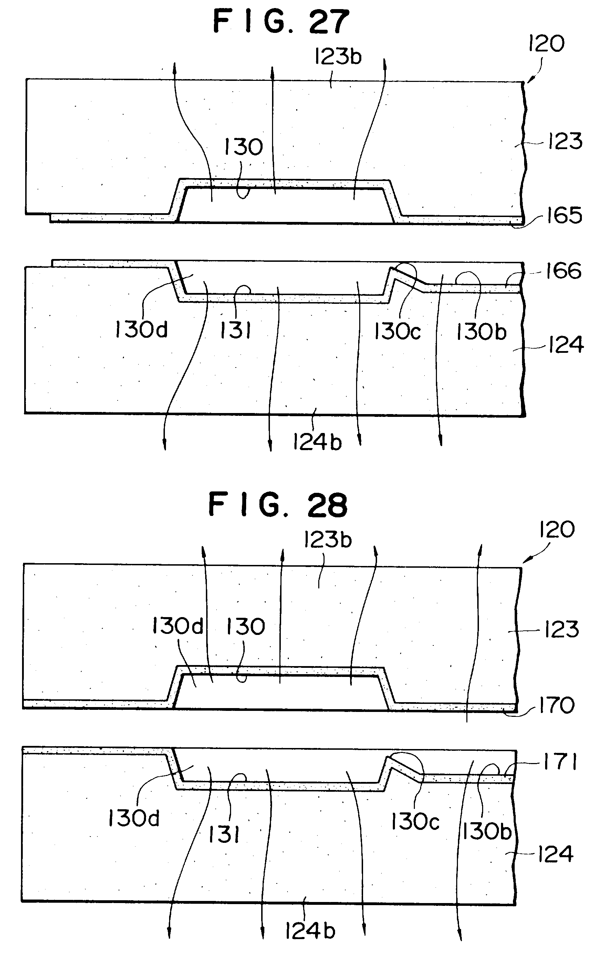

Fig. 27 is a schematic section showing dies provided in another embodiment (embodiment 12) of the present invention. In this embodiment, as shown in Fig. 27, like the foregoing embodiment, the upper and the lower dies 123 and 124 provide the resin press-fitting portions 130 and 131 on which the porous films 165 and 166 are pasted, respectively. Before any clogging takes place, that is, at a predetermined number of moldings times, these porous films 165 and 166 are replaced with new ones. Hence, this embodiment offers the same effect as the embodiment 11.

### (Embodiment 13)

Fig. 28 is a schematic section showing dies provided in another embodiment (embodiment 13) of the present invention. In this embodiment 13, as shown in Fig. 28, the upper and the lower dies 123 and 124 provide the resin press-fitting portions 130 and 131 on which porous films 170 and 171 are formed. These porous films 170 and 171 are formed of a coat of titanium nitride (TiN), chromium (Cr) or the like. The coat has a thickness of about 1 µm to 5 µm and is applied by an electrolytic process. The coat is porous and thus contains lots of air vents, each of whose diameter is about 0.1 µm to 0.3 µm. This kind of structure is resistant against clogging because it is a coating film and contains air vents through which resin particles are not permitted to pass. Hence, the structure is durable for a long time.

### (Embodiment 14)

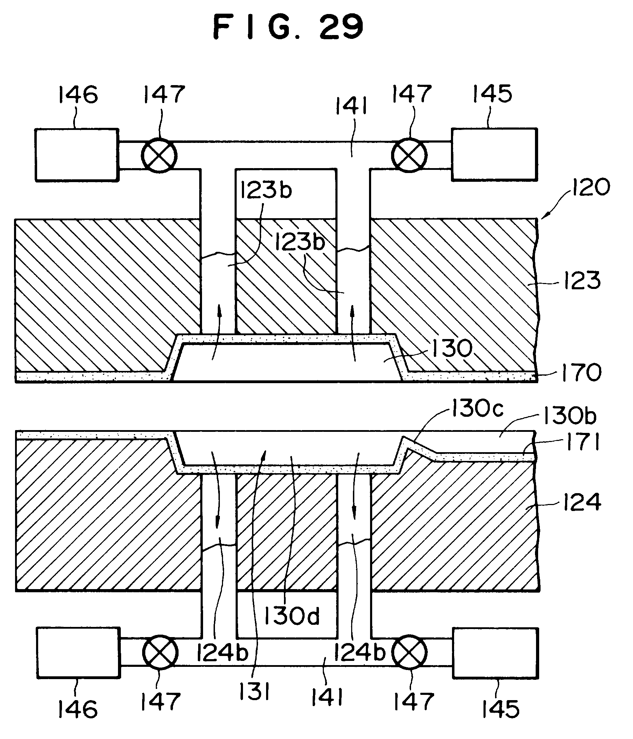

Fig. 29 is a model view showing an essential portion of the transfer molding apparatus according to another embodiment (embodiment 24) of the present invention. In this embodiment, the upper and the lower dies 123 and 124 are formed of not a porous material but a normal hard metal. In the dies, the base ventilating portions 123b and 124b are formed of pores made on the upper and the lower dies 123 and 124. Those pores are connected to the communicating pipe 141. If these ventilating portions 123b and 124b are located at least in the cavity 130d, no void takes place in the resulting mold. In addition, the base ventilating portions 123b and 124b formed of pores may apply to the foregoing embodiments 11 and 12.

As described above, the inventions of the present inventors has bee concretely described along the embodiments. The present invention is not limited to the foregoing embodiments. It goes without saying that various kinds of transformations is made possible without departing from the spirit of the invention.

The foregoing description has been concerned with the transfer molding technique that corresponds to the background of the present invention. The applied field of the present invention is not limited to it. For example, the invention may apply to a normal injection molding press for molding only a resin from only resin or a technique for molding a molten material such as die cast or rubber molding.

The present invention may apply to at least the molding technique.

The representative inventions disclosed in the present application provide the following effects.

(1) The upper and the lower dies include the two-stage ventilating portions for guiding the air left in the resin press-fitting portions such as cavities out of the dies. Hence, those dies are not required to provide on the parting faces of the dies. It means that it is possible to prevent occurrence of a flaw on the outer lead or defective transformation resulting from the undesired resin hardened in the air vent.
(2) Provision of no air vent makes it possible to avoid shortage of resin to be filled in the cavity, which results from the resin clogging often takes place in the air vent. Hence, no foam (void) or sink takes place in the molded product. This makes contribution to keeping the quality of the molded product (semiconductor device) constant or higher.
(3) The dies provide the two-stage ventilating portions for guiding out the air left in the resin press-fitting portion. Hence, it is not necessary to provide any device for preventing occurrence of voids such as over-runners, dummy cavities, air vents or flow cavities. Further, the design of the dies is made easier and the size of the dies is made smaller.
(4) The ventilating portion is having the base ventilating portion and the surface ventilating portion. The surface ventilating portion for contacting the molten resin has air vents in smaller diameter than the base ventilating portion. Hence, no clogging takes place in the base ventilating portion.
(5) The surface ventilating portion is replaceable. Hence, it may be replaced at a predetermined number of molding times, and thus it is possible to prevent defective molding resulting from the resin clogging.
(6) The surface ventilating portion is formed by transforming the extensible porous films stretched on the parting faces of the upper and the lower dies through the effect of the sucking discharge (and the implanting pressure of the resin). The resulting mold is made to be a proper mold with no impairment of its outer appearance.
(7) The surface ventilating portion is formed of the extensible porous films stretched on the parting faces of the upper and the lower dies. Hence, when opening the dies, the restoring force, that is, the flattening force of the porous films serves to release the molded product from the dies. This force may be a substitute of the ejector pins.
(8) In molding a product, for each molding process, the porous film is fed between the parting faces of the upper and the lower dies through the effect of the porous film feeding mechanism. Hence, no clogging takes place in the surface ventilating portion, and the resulting mold is made to be a proper mold with no impairment of its outer appearance.
(9) The sucking means communicating with the ventilating portion starts to operate when the resin is pressed in the resin press-fitting portions. Hence, the air left in the portions is swiftly discharged out so that the molding is properly executed without having to impair the outer appearance and bring about voids. This results in improving the yield.
(10) When opening the dies, the compressed gas supplying means communicating with the ventilating portion is operated for pressing the molded product out of the upper and the lower dies through the effect of the compressed gas. The release of the molded product is thus made positive.
(11) When opening the dies, the molded product is taken out of the upper and the lower dies through the effect of the restoring force of the porous films and the compressed gas supplying means. Hence, no ejector pin is required. It means that no ejector pin pricks the mold. This leads to preventing occurrence of a chip crack or a package slit.
(12) Since no ejector pin is required, the die structure is simplified. Hence, the design and the manufacture of the die is made easier, which makes it possible to reduce the manufacturing time and cost.

## Claims

1. A method for manufacturing a semiconductor integrated circuit device having a step of sealing a semiconductor with a heat-curing mold resin, comprising the steps of:
(a) preparing a chip-lead compound (40) having plural semiconductor chips, a lead frame (42) or a thin film wiring sheet containing plural inner leads indirectly or directly connected with electrodes formed on first main faces of said semiconductor chips;
(b) in a molding apparatus having a first die (76) and a second die (78) being matched to said first die (76) so that plural mold cavities (43) are formed for sealing said plural semiconductor chips, at least part of an inner side of each of said mold cavities (43) of at least one of said first and second dies (76, 78) being formed of a porous material for inhibiting intrusion of said mold resin to a predetermined length and allowing part of gas components to pass for preventing occurrence of voids, placing said chip-lead compound (40) between said first and second dies (76, 78);
(c) clamping said dies (76, 78) in the state of placing said chip-lead compound (40) between said first and second dies (76, 78);
(d) opening said mold cavities (43) formed by said matched dies (76, 78) to the atmosphere through said porous material or implanting said mold resin into said mold cavities (43) at a far lower pressure than the implanting pressure of said mold resin, for sealing predetermined portions of said chip-lead compound (40) with said mold resin; and
(e) opening said both dies (76, 78) as injecting gas into said mold cavities (43) through said porous portions of said mold cavities, for releasing said sealed chip-lead compound (40) from at least one of said first and second dies (76, 78).

2. A method for manufacturing a semiconductor integrated circuit as claimed in claim 1, wherein when said mold resin is implanted into said mold cavities (43), gas left in said mold cavities (43) are discharged through said porous portion by discharge means.

3. A method for manufacturing a semiconductor integrated circuit as claimed in claim 2, wherein said molding apparatus includes ventilating portions (84a) formed of a porous material and having air vents (85) communicating with said mold cavities (43) and filter layers (88, 89) having communicating pores (90) formed on the surface of said ventilating portions (84a) and communicating with said air vents (85), said pores (90) serving to inhibit intrusion of said mold resin into said air vents (85) and allow at least part of gas components to pass therethrough for preventing occurrence of voids.

4. A method for manufacturing a semiconductor integrated circuit as claimed in claim 3, wherein said molding apparatus includes ventilating portions (84a) made of a porous material and having air vents (85) communicating with said mold cavities (43) and fine porous portions (100) buried in said air vents (85) to a predetermined depth and communicating with said air vents (85) for forming communicating pores (90) each having a smaller diameter than said air vents (85).

5. A method for manufacturing a semiconductor integrated circuit having a step of sealing a semiconductor chip with heat-curing mold resin, comprising the steps of:
(a) preparing a chip-lead compound (40) having plural semiconductor chips and a lead frame (42) or a thin film wiring sheet
(b) in a molding apparatus having a first die (76) and a second die (78) being matched to said first die (76) so that plural mold cavities (43) are formed for sealing said plural semiconductor chips, the substantially overall surface of an inner side of each of said mold cavities (43) of at least one of said first and second dies (76, 78) being formed of a porous material for inhibiting intrusion of said mold resin to a predetermined length and allowing part of gas components to pass therethrough for preventing occurrence of voids, placing said chip-lead compound (40) between said first and second dies (76, 78);
(c) clamping said dies (76, 78) in the state of placing said chip-lead compound (40) between said first and second dies (76, 78);
(d) opening said mold cavities (43) formed by said matched dies (76, 78) to the atmosphere through said porous material or implanting said mold resin into said mold cavities (43) at a far lower pressure than the implanting pressure of said mold resin, for sealing predetermined portions of said chip-lead compound (40) with said mold resin; and
(e) opening said both dies (76, 78) as injecting gas into said mold cavities (43) through said porous material of said mold cavities (43), for releasing said sealed chip-lead compound (40) from at least one of said first and second dies (76, 78).

6. A method for manufacturing a semiconductor integrated circuit device as claimed in claim 5, wherein when opening said first and second dies (76, 78) from each other, gas is injected from the outside to said mold cavities (43) through said porous material.

7. A method for manufacturing a semiconductor integrated circuit device as claimed in claim 6, wherein when said mold resin is implanted into said mold cavities (43), gas left in said mold cavities (43) are discharged through said porous material by discharge means.

8. A method for manufacturing a semiconductor integrated circuit device having a step of sealing a semiconductor with a heat-curing mold resin, comprising the steps of:
(a) preparing a chip-lead compound (100) having plural semiconductor chips, a lead frame (42) or a thin film wiring sheet containing plural inner leads indirectly or directly connected with electrodes formed on first main faces of said semiconductor chips;
(b) in a molding apparatus having a first die (76) and a second die (78) being matched to said first die (76) so that plural mold cavities (43) are formed for sealing said plural semiconductor chips, at least a gate-opposed portion of an inner side of each of said mold cavities (43) of at least one of said first and second dies (76, 78) being formed of a porous material for inhibiting intrusion of said mold resin to a predetermined depth and allowing part of gas components to pass through said porous material for preventing occurrence of voids, placing said chip-lead compound (40) between said first and second dies (76, 78);
(c) clamping said dies (76, 78) in the state of placing said chip-lead compound (40) between said first and second dies (76, 78);
(d) opening said mold cavities (43) formed by said matched dies (76, 78) to the atmosphere through said porous material or implanting said mold resin into said mold cavities (43) at a far lower pressure than the implanting pressure of said mold resin, for sealing predetermined portions of said chip-lead compound (40) with said mold resin; and
(e) opening said both dies (76, 78) as injecting gas into said mold cavities (43) through said porous portions of said mold cavities, for releasing said sealed chip-lead compound (40) from at least one of said first and second dies (76, 78).

9. A method for manufacturing a semiconductor integrated circuit device as claimed in claim 8, wherein said porous portion is formed in at least one of said first and second dies (76, 78).

10. A method for manufacturing a semiconductor integrated circuit device having a step of sealing a semiconductor with a heat-curing mold resin, comprising the steps of:
(a) preparing a chip-lead compound (40) having plural semiconductor chips, a lead frame (42) or a thin film wiring sheet containing plural inner leads indirectly or directly connected with electrodes formed on first main faces of said semiconductor chips;
(b) in a molding apparatus having a first die (76) and a second die (78) having plural mold cavities (43), one or more pots (44) for holding resin tablets (46), and one or more runners (47) for connecting said mold cavities (43) with said pots (44), said second die (78) being matched to said first die (76) so that plural mold cavities (43) are formed for sealing said plural semiconductor chips, at least part of an inner side of a plunger (45) provided in each of said pots (44), said runners (47) and said pots (44) being formed of a porous material for inhibiting intrusion of said mold resin to a predetermined length and allowing part of gas components to pass therethrough for preventing occurrence of voids, placing said chip-lead compound (40) between said first and second dies (76, 78);
(c) clamping said dies (76, 78) in the state of placing said chip-lead compound (40) between said first and second dies (76, 78);
(d) implanting said mold resin from said pots (44) into said mold cavities (43) through said runners (47) for sealing predetermined portions of said chip-lead compound (40) with said mold resin; and
(e) opening said both dies (76, 78), for releasing said sealed chip-lead compound (40) from at least one of said first and second dies (76, 78).

11. A method for manufacturing a semiconductor integrated circuit as claimed in claim 10, wherein the inner surface of each of said mold cavities (43) and runners (47) are formed of a porous material, said porous material serving to inhibit intrusion of said mold resin to a predetermined depth and allow at least part of gas components to pass for preventing occurrence of voids.

12. A method for manufacturing a semiconductor integrated circuit as claimed in claim 10, wherein the inner surface of each of said mold cavities (43), said runners (47) and said pots (44) is formed of a porous material, said porous material serving to inhibit intrusion of said mold resin to a predetermined depth and allow part of gas components to pass for preventing occurrence of voids.

13. A method for manufacturing a semiconductor integrated circuit device as claimed in claim 10, wherein the inner surface of each of said mold cavities (43), said runners (47), said pots (44), and said plungers (45) slidably located in said pots and for pressing said mold resin is formed of a porous material, said porous material serving to inhibit intrusion of said mold resin to a predetermined depth and allow at least part of gas components to pas for preventing occurrence of voids.

14. A method for manufacturing a semiconductor integrated circuit device having a step of sealing a semiconductor with a heat-curing mold resin, comprising the steps of:
(a) preparing a chip-lead compound (40) having plural semiconductor chips, a lead frame (42) or a thin film wiring sheet containing plural inner leads indirectly or directly connected with electrodes formed on first main faces of said semiconductor chips;
(b) in a molding apparatus having a first die (76) and a second die (78) having plural mold cavities (43), plural pots (44) formed at a predetermined number of said mold cavities (43) and each for holding for resin tablets (46), and plural runners (47) for connecting said mold cavities (43) with said pots (44), said second die (78) being matched to said first die (76) so that plural mold cavities (43) are formed for sealing said plural semiconductor chips, at least part of an inner side of each of said mold cavities (43), said pots (44) and said runners (47) being formed of a porous material for inhibiting intrusion of said mold resin to a predetermined depth and allowing part of gas components to pass therethrough for preventing occurrence of voids, inserting said resin tablet (46) in a resin tablet inserting portion formed in said lower die from between said upper and lower dies (76, 78);
(c) placing said chip-lead compound (40) between said opened upper and lower dies (76, 78);
(d) clamping said dies (76, 78) in the state of placing said chip-lead compound (40) between said first and second dies (76, 78);
(e) implanting said mold resin from said pots (44) into said mold cavities (43) through said runners (47), for sealing predetermined portions of said chip-lead compound (40) with said mold resin; and
(f) opening said both dies (76, 78) for releasing at least one of said upper and lower dies (76, 78) from said sealed chip-lead compound (40).

15. A method for manufacturing a semiconductor integrated circuit device having a step of sealing a semiconductor chip with heat-curing mold resin, said IC device being inferior in its characteristic by physically transforming said sealing portion if a sealed portion is released by ejector pins (26) provided in a molding apparatus, comprising the steps of:
(a) preparing a chip-lead compound (40) having plural semiconductor chips, a lead frame (42) or a thin film wiring sheet containing plural inner leads indirectly or directly connected with electrodes formed on first main faces of said semiconductor chips;
(b) in a molding apparatus having a first die (76) and a second die (78) being matched to said first die (76) so that plural mold cavities are formed for sealing said plural semiconductor chips, at least part of an inner side of a plunger (45) provided in each of said pots (44), said runners (47) and said pots (44) being formed of a porous material for inhibiting intrusion of said mold resin to a predetermined length and allowing part of gas components to pass therethrough for preventing occurrence of voids, placing said chip-lead compound (40) between said first and second dies (76, 78);
(c) clamping said dies (76, 78) in the state of placing said chip-lead compound (40) between said first and second dies (76, 78);
(d) implanting said mold resin in said mold cavities (43) formed by said clamped dies (76, 78) for sealing predetermined portions of said chip-lead compound (40) with said mold resin; and
(e) opening said both dies (76, 78) as injecting gas into said mold cavities (43) through said porous portions of said mold cavities, for releasing said sealed chip-lead compound (40) from at least one of said first and second dies (76, 78).

16. A molding apparatus for sealing a semiconductor chip with a resin package, comprising:
a first die (123);
a second die (124) provided to relatively move to or off said first die (123) and matched to said first die (124) for forming mold cavities (130d) suited to said package; and
wherein at least one of said first and second dies is having a die body (84 or 87) made of a porous material and provided with a ventilating portion (123b, 124b) containing air vents (85) and a fine porous portion (100) buried in each of said air vents (85) to a predetermined depth from each inner surface of said mold cavities (130d), said fine porous portion (100) containing communicating pores (140) each having a smaller inner diameter than said air vents (85) and serving to inhibit intrusion of said mold resin (125) and allow at least part of gas components to pass therethrough, and gas components left in said mold cavities (130d) are discharged out through said communicating pores (140).

17. A molding apparatus as claimed in claim 16, wherein said fine porous portion (100) contains a coating layer (103) on its surface.

18. A method for manufacturing a semiconductor integrated circuit device, characterized in that at least part of each inner surface of mold cavities (130d) formed in dies (123, 124) for transfer molding is formed of a porous medium or contains such lots of pores (140) as inhibiting intrusion of sealing resin (128) down to a predetermined depth of said inner surface.

19. A method for manufacturing a semiconductor integrated circuit device formed so that at least part of each inner surface of mold cavities (130d) formed in dies (123, 124) for transfer molding is formed of a porous medium or contains such lots of pores (140) as inhibiting intrusion of sealing resin.

20. A method for manufacturing a semiconductor integrated circuit device formed so that at least part of an inner surface of the portion of each die (123 or 124) for transfer molding except mold cavities (130d), in which portion sealing resin is flowing, is made porous or contains such lots of pores (140) as inhibiting intrusion of said sealing resin.

21. A molding method for manufacturing a mold by press-fitting molten resin (128) in resin press-fitting portions (130, 131) formed when an upper die (123) is matched to a lower die (124), characterized in that a molding process is executed as discharging air left in said resin press-fitting portions (130, 131) out of said dies (123, 124) through a two-stage ventilating portions (123a, 124a, 150a, 151b) having base ventilating portions (123a, 124a) formed in said upper or lower die and a surface ventilating portions (150a, 151b) located on the surface of said base ventilating portions (123a, 124a) and contacting said molten resin (128).

22. A molding method as claimed in claim 21, wherein said surface ventilating portion (150a, 151a) is made porous and may be replaced at a predetermined number of moldings.

23. A molding method as claimed in claim 22, characterized in that said surface ventilating portion (150a, 151a) is formed by transforming an extensible porous film (150, 151) stretched on each parting face of said upper and lower dies (123, 124) through mold clamping of said upper and lower dies (123, 124) and press-fitted resin (128) and the restoring, that is, flattening force of said porous film (150, 151) make a mold released from said upper and lower dies (123, 124).

24. A molding method as claimed in claims 21 to 23, characterized in that air left in said resin press-fitting portions (130, 131) are forcibly discharged out through said ventilating portions (123b, 124b, 150a, 151a) when resin is press-fitted and compressed air is fed to said resin press-fitting portions (130, 131) through said ventilating portions (123b, 124b, 150a, 151a) for releasing the mold from said upper and lower dies (123, 124) when opening said dies.

25. A molding apparatus for manufacturing a mold by press-fitting molten resin (128) to resin press-fitting portions (130, 131) formed when an upper dies (123) is matched to a lower die (124), comprising a two-stage ventilating portion (123b, 124b, 150a, 151a) provided in at least one of upper and lower dies (123, 124) and for guiding out air left in said resin press-fitting portions (130, 131).

26. A molding apparatus as claimed claim 25, wherein said two-stage ventilating portion (123b, 124b, 150a, 151a) is having base ventilating portions (123b, 124b) formed in said upper and lower dies (123, 124) and surface ventilating portions (150a, 151a) located on the surface of said base ventilating portion (123b, 124b) and contacting said molten metal (128).

27. A molding apparatus as claimed in claim 26, wherein said surface ventilating portions (150a, 151a) and base ventilating portions (123a, 124a) are both formed of a porous material and air vents (85) formed in said surface ventilating portions (151a, 151b) are smaller in diameter than those formed in said base ventilating portions (123b, 124b) and are replaceable.

28. A molding apparatus as claimed in claim 27, wherein said surface ventilating portion (150a or 151a) is formed of an extensible porous film (150 or 151) stretched on each parting face (123a or 124a) of said upper and lower dies (123, 124).

29. A molding apparatus as claimed in claim 28, further comprising porous film feeding mechanisms (152, 153) for feeding said porous film (150, 151) between the parting faces (123a, 124a) of said upper and lower dies (123, 124) at a predetermined number of moldings.

30. A molding apparatus as claimed in claim 29, further comprising sucking means connected to said ventilating portions (123b, 124b, 150a, 151a) and for forcibly sucking air from said resin press-fitting portions (130, 131) to the outside and compressed gas supplying means connected to said ventilating portions (123b, 124b, 150a, 151a) and for supplying compressed gas to said resin press-fitting portions (130, 131).

31. A method for manufacturing a semiconductor integrated circuit device comprising the step of implanting sealing resin (128) between an inner surface of each mold cavity (130d) of a die (123 or 124) and a chip-lead compound to be sealed with a pair of sheets laid therebetween, each of said sheets being porous or containing such lots of porous (140) as inhibiting intrusion of said sealing resin (128).

32. A molding method for manufacturing a mold by press-fitting molten metal (128) in resin press-fitting portions (130, 131) formed when an upper die (123) is matched to a lower die (124), comprising the step of:
press-fitting said molten metal (128) between said pair of dies (123, 124) for manufacturing the product, at least one of said dies (123, 124) having a two-stage ventilating portion (123b, 124b, 150a, 151a) having base ventilating portions (123b, 124b) and surface ventilating portions (150a, 151a) located on the surfaces of said base ventilating portions and contacting said molten metal (128).

33. A molding method as claimed in claim 32, wherein said surface ventilating portion (150a or 151a) is formed of a porous material, allowed to be loaded to or unloaded from said base ventilating portion (123b or 124b) at any position, and replaceable at a predetermined number of moldings.

34. A molding method as claimed in claim 33, wherein said surface ventilating portion (150a or 151a) is formed of an extensible porous film (150 or 151) stretched along each parting face (123a or 124a) of said upper and lower dies (123, 124).

35. A molding method as claimed in any one of claims 32 to 34, further comprising the steps of forcibly discharging air left in said resin press-fitting portions (130, 131) through said ventilating portions (123b, 124b, 150a, 151a) by using discharging means when said molten resin (128) is press-fitted, and supplying compressed air from an external air feeder through said ventilating portions (123b, 124b, 150a, 151a) when opening said dies for releasing a mold from said upper and lower dies (123, 124).

36. A molding apparatus for manufacturing a mold by press-fitting molten metal in resin press-fitting portions (130, 131) when an upper die (123) is matched to a lower die (124), comprising a two-stage ventilating portion (123b, 124b, 150a, 151a) located in at least one of said upper and lower dies (123, 124) and having base ventilating portions (123b, 124b) and surface ventilating portions (150a, 151a) located on the surfaces of said base ventilating portions (123b, 124b) and contacting said molten metal (128).

37. A molding apparatus as claimed in claim 36, wherein said base ventilating portions (123b, 124b) and surface ventilating portions (150a, 151a) are both formed of a porous material, said surface ventilating portion (150a or 151a) contains air vents (85) in smaller diameter than said base ventilating portion (123b or 124b), and said surface ventilating portion (150a or 151a) is replaceable about said base ventilating portion (123b or 124b).

38. A molding apparatus as claimed in claim 36 or 37, wherein said surface ventilating portion (150a or 151a) is formed of an extensible porous film (150 or 151) stretched on each parting face (123a or 124a) of said upper and lower dies (123, 124).

39. A molding apparatus as claimed in claim 38, further comprising porous film feeding mechanisms (152, 153) for feeding said porous films (150, 151) between the parting faces (123a, 124a) of said upper and lower dies (123, 124) at a predetermined number of moldings.

40. A molding apparatus as claimed in claim 35, further comprising sucking means connected to said ventilating portions (123b, 124b, 150a, 151a) and for forcibly sucking air from said press-fitting portions (130, 131) to the outside, and compressed gas supplying means connected to said ventilating portions (123b, 124b, 150a, 151a) and for supplying compressed gas to said resin press-fitting portions (130, 131).
